# EUROPEAN PATENT APPLICATION

(11) **EP 4 432 361 A1**
(43) Date of publication of application: **18.09.2024**
(21) Application number: 24151242.5
(22) Date of filing: 10.01.2024
(51) Int. Cl.: H01L 27/12, H01L 29/786

(54) **DISPLAY DEVICE AND METHOD OF FABRICATING DISPLAY DEVICE**

(30) Priority: 17.03.2023 KR 20230035165
(71) Applicant: Samsung Display Co., Ltd., Yongin-si, Gyeonggi-do 17113 (KR)
(72) Inventor: CHO, Dong Yeon, Yongin-si (KR); PARK, Ui Young, Yongin-si (KR)
(74) Representative: Marks & Clerk LLP

(57) **Abstract**

A display device includes a circuit layer disposed on a substrate and comprising a first transistor, and a light-emitting element disposed on the circuit layer and electrically connected to the first transistor. The first transistor comprises a first active area, a first drain electrode disposed on a side of the first active area, a first source electrode disposed on another side of the first active area, a gate insulating film disposed on the first active area, an oxygen-providing film disposed on the gate insulating film, and a first gate electrode disposed on the oxygen-providing film. The oxygen-providing film has a higher oxygen ratio than the gate insulating film.

## Description

### BACKGROUND

### 1. Technical Field

This disclosure relates to a display device, and methods of fabricating the same.

### 2. Description of the Related Art

As the information-oriented society evolves, various demands for display devices are ever increasing. Display devices may be flat panel display devices such as a liquid-crystal display device, a field emission display device, and a light-emitting display device. Light-emitting display devices may include an organic light-emitting display device including organic light-emitting diodes as light-emitting elements, or a light-emitting diode display device including inorganic light-emitting diodes such as light-emitting diodes (LEDs) as light-emitting elements.

A thin-film transistor can be fabricated on a glass substrate or a plastic substrate, and thus it is broadly used as a switching element of a display device such as a liquid crystal display device and an organic light-emitting display device.

Based on the material forming the active layer, thin-film transistors may be sorted into an amorphous silicon thin-film transistor in which amorphous silicon is used as the active layer, a polycrystalline silicon thin-film transistor in which polycrystalline silicon is used as the active layer, and an oxide semiconductor thin-film transistor in which oxide semiconductor is used as the active layer.

Among them, an oxide semiconductor thin-film transistor (oxide semiconductor TFT) has advantages in that an oxide forming the active layer can be formed at a relatively low temperature, mobility is high, and the resistance changes largely depending on the content of oxygen, so that desired physical properties may be readily obtained. Since the oxide semiconductor is transparent due to the nature of oxide, it is also advantageous for implementing a transparent display.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

Aspects of the disclosure provide a display device that includes transistors in which the reliability of characteristics of semiconductor devices in an active layer is improved, and a method of fabricating the same.

Aspects of the disclosure also provide a display device including transistors in which an oxide semiconductor has high mobility, and a method of fabricating the same.

It should be noted that aspects of the disclosure are not limited to the above-mentioned aspects; and other aspects of the disclosure will be apparent to those skilled in the art from the following descriptions.

According to an aspect of the disclosure, there is provided a display device that includes a circuit layer disposed on a substrate and including a first transistor, and a light-emitting element disposed on the circuit layer and electrically connected to the first transistor. The first transistor includes a first active area, a first drain electrode disposed on a side of the first active area, a first source electrode disposed on another side of the first active area, a gate insulating film disposed on the first active area, an oxygen-providing film disposed on the gate insulating film, and a first gate electrode disposed on the oxygen-providing film. The oxygen-providing film has a higher oxygen ratio than the gate insulating film.

In an embodiment, the oxygen-providing film may overlap (e.g. partially or completely cover) the first active area in the first transistor (e.g. in a plan view).

In an embodiment, the first active area may be disposed under the oxygen-providing film.

In an embodiment, the oxygen-providing film may directly contact the gate insulating film, and/or the gate insulating film may directly contact the first active area (e.g. the oxygen-providing film may directly contact the gate insulating film, and the gate insulating film may directly contact the first active area).

In an embodiment, the oxygen-providing film may be spaced apart from the first active area, and the gate insulating film may be disposed between the oxygen-providing film and the first active area.

In an embodiment, an amount of oxygen releasable (e.g. released) from the oxygen-providing film may be greater than an amount of oxygen releasable (e.g. released) from the gate insulating film.

In an embodiment, the amount of oxygen releasable (e.g. released) from the oxygen-providing film may be about three times or more the amount of oxygen releasable (e.g. released) from the gate insulating film.

In an embodiment, a total amount of oxygen releasable (e.g. released) from the oxygen-providing film under conditions of a rising-temperature velocity of about 60°C/min and a temperature range of about 50°C to about 1,200°C using a thermal desorption spectroscopy (TDS) may be equal to or greater than about 2.5 × 10¹⁴ molecules/cm².

In an embodiment, the gate insulating film and the oxygen-providing film may include silicon oxide (SiOₓ), an O/Si ratio of the gate insulating film may be less than about 1.83, and an O/Si ratio of the oxygen-providing film may be equal to or greater than about 1.83.

In an embodiment, a thickness of the oxygen-providing film may be in a range of from about two to about five times a thickness of the gate insulating film.

In an embodiment, the thickness of the oxygen-providing film may be in a range from about 20 nm to about 50 nm.

In an embodiment, the oxygen-providing film may include depressions and elevations on an upper surface (e.g. a surface facing away from the gate insulating film), and wherein a maximum height difference between the depressions and elevations may be less than about 2 nm.

In an embodiment, the first active area may include at least one of, an ITGZO-based semiconductor, an ITGO-based semiconductor, and an IGO-based oxide semiconductor.

In an embodiment, the circuit layer may further include a second transistor and a third transistor. The second transistor may include a second active area, a second drain electrode disposed on one side of the second active area, and a second source electrode disposed on another side of the second active area, the gate insulating film disposed on the second active area, and a second gate electrode disposed on the gate insulating film. The third transistor may include a third active area, a third drain electrode disposed on one side of the third active area, a third source electrode disposed on another side of the third active area, a gate insulating film disposed on the third active area, and a third gate electrode disposed on the gate insulating film. At least one of the second transistor and the third transistor may not include the oxygen-providing film disposed on the gate insulating film.

In an embodiment, one of the first transistor, the second transistor and the third transistor may be a driving transistor for driving the light-emitting element, and the other two of the first transistor, the second transistor and the third transistor may be switching transistors for controlling electric current flowing through the driving transistor and the light-emitting element.

According to an aspect of the disclosure, there is provided a method of fabricating a display device. The method includes forming an active layer on a substrate, forming a gate insulating film on the active layer, forming an oxygen-providing film on the gate insulating film, and forming a metal layer on the oxygen-providing film. The forming of the gate insulating film includes performing a deposition process using a first gas and a second gas as reactive gases. The forming of the oxygen-providing film includes performing a deposition process using the first gas and the second gas as reactive gases. The first gas is silane (SiH₄) gas. The second gas is nitrous oxide (N₂O) gas. A ratio of a flow rate of the first gas to a flow rate of the second gas in the forming of the oxygen-providing film is smaller than a ratio of a flow rate of the first gas to a flow rate of the second gas in the forming of the gate insulating film.

In an embodiment, the ratio of the flow rate of the first gas to the flow rate of the second gas may be less than or equal to about 1:55 in the forming of the oxygen-providing film.

In an embodiment, the gate insulating film and the oxygen-providing film may comprise silicon oxide (SiOₓ), an O/Si ratio of the gate insulating film may be less than about 1.83, and an O/Si ratio of the oxygen-providing film may be equal to or greater than about 1.83.

According to an aspect of the disclosure, there is provided a method of fabricating a display device. The method includes forming an active layer on a substrate, forming a gate insulating film on the active layer, and forming a metal layer on an oxygen-providing film. The forming of the gate insulating film includes performing a deposition process using a first gas and a second gas as reactive gases, and performing a plasma treatment process using a third gas as a reactive gas. The first gas is silane (SiH₄) gas. The second gas is nitrous oxide (N₂O) gas. The third gas includes at least one of nitrous oxide (N₂O) gas and oxygen (O₂) gas.

In an embodiment, the performing of the deposition process may be performed using a PECVD process, an energy level of a plasma in the PECVD process of the deposition process may be greater than an energy level of a plasma in the plasma treatment process, and a flow rate of the second gas in the deposition process may be smaller than a flow rate of the third gas in the plasma treatment process.

At least some of the above and other features of the invention are set out in the claims.

According to an embodiment of the disclosure, the reliability of characteristics of semiconductor devices in active layers of transistors in a display device can be improved.

According to an embodiment of the disclosure, an oxide semiconductor of transistors in a display device can have high mobility.

It should be noted that effects of the disclosure are not limited to those described above and other effects of the disclosure will be apparent to those skilled in the art from the following descriptions.

### BRIEF DESCRIPTION OF THE DRAWINGS

The above and other aspects and features of the disclosure will become more apparent by describing in detail embodiments thereof with reference to the attached drawings, in which:
FIG. 1 is a schematic perspective view showing a display device according to an embodiment of the disclosure.
FIG. 2 is a schematic cross-sectional view of a display device, taken along line I - I' of FIG. 1.
FIG. 3 is a schematic plan view showing the display substrate and other components according to an embodiment.
FIG. 4 is a schematic view showing pixels and lines of a display device according to an embodiment.
FIG. 5 is a schematic plan view showing the display area of the display substrate according to an embodiment.
FIG. 6 is a schematic plan view showing the display area of the color conversion substrate according to an embodiment.
FIG. 7 is a schematic cross-sectional view of the display device, taken along line II - II' of FIG. 5 and 6.
FIG. 8 is a schematic diagram of an equivalent circuit of a pixel of a display device according to an embodiment of the disclosure.
FIG. 9 is a schematic plan view showing the thin-film transistor layer of the display device according to an embodiment.
FIG. 10 is a schematic cross-sectional view taken along line III - III' of FIG. 9.
FIG. 11 is a schematic cross-sectional view taken along line IV - IV' of FIG. 9.
FIG. 12 is a schematic cross-sectional view showing a gate insulating film and an oxygen-providing film according to an embodiment of the disclosure.
FIG. 13 is a schematic graph for comparing the amount of oxygen releasable from a gate insulating film with the amount of oxygen releasable from an oxygen-providing film versus the temperature according to an embodiment.
FIG. 14 is a schematic graph for comparing the total amount of oxygen releasable from the gate insulating film with the total amount of oxygen releasable from the oxygen-providing film according to an embodiment.
FIG. 15 is a schematic cross-sectional view of a display device according to another embodiment of the disclosure.
FIG. 16 is a schematic cross-sectional view of a display device according to another embodiment of the disclosure.
FIG. 17 is a flowchart for illustrating a method of fabricating a display device according to an embodiment of the disclosure.
FIGS. 18 to 27 are schematic cross-sectional views showing processing steps of a method of fabricating a display device according to an embodiment.
FIG. 28 is a flowchart for illustrating a method of fabricating a display device according to another embodiment of the disclosure.
FIG. 29 is a flowchart for illustrating step S220 of FIG. 28.
FIGS. 30 to 35 are schematic cross-sectional views showing processing steps of a method of fabricating a display device according to another embodiment of the disclosure.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the drawings, sizes, thicknesses, ratios, and dimensions of the elements may be exaggerated for ease of description and for clarity. Like numbers refer to like elements throughout.

As used herein, the singular forms, "a," "an," and "the" are intended to include the plural forms as well, unless the context clearly indicates otherwise.

The terms "comprises," "comprising," "includes," and/or "including,", "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

In the specification and the claims, the term "and/or" is intended to include any combination of the terms "and" and "or" for the purpose of its meaning and interpretation. For example, "A and/or B" may be understood to mean any combination including "A, B, or A and B." The terms "and" and "or" may be used in the conjunctive or disjunctive sense and may be understood to be equivalent to "and/or."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

The term "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

"About" or "approximately" or "substantially" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

It will also be understood that when a layer is referred to as being "on" another layer or substrate, it can be directly on the other layer or substrate, or intervening layers may also be present.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

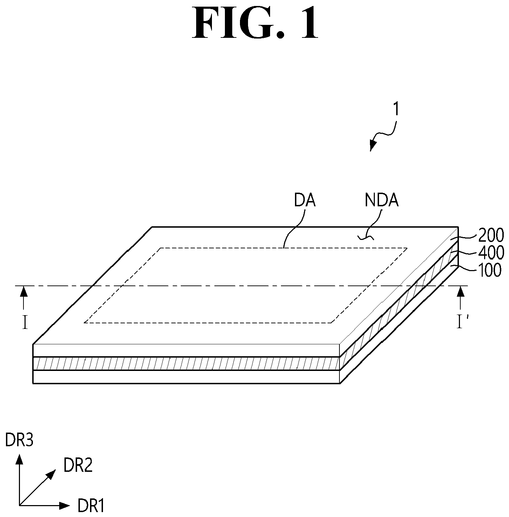

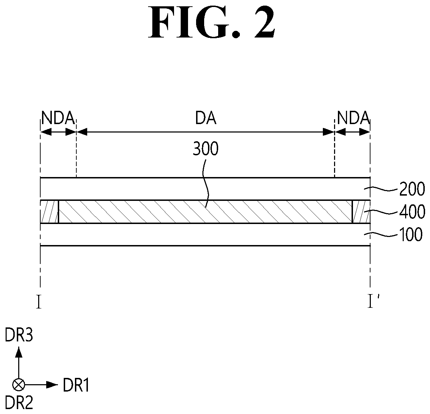

FIG. 1 is a schematic perspective view showing a display device according to an embodiment of the disclosure. FIG. 2 is a schematic cross-sectional view of a display device, taken along line I - I' of FIG. 1.

A display device 1 shown in FIGS. 1 and 2 may be employed in a variety of electronic devices including small-and-medium sized electronic devices such as a tablet PC, a smartphone, a vehicle navigation unit, a camera, a center information display (CID) installed in vehicles, a wrist-type electronic device, a personal digital assistant (PMP), a portable multimedia player (PMP) or a game machine, and medium-and-large electronic devices such as a television, an electric billboard, a monitor, a personal computer or a laptop computer. It should be understood that the above-listed electronic devices are merely illustrative and the display device 1 may be employed in a variety of other electronic devices without departing from the scope of the disclosure.

According to an embodiment of the disclosure, the display device 1 may have a rectangular shape in plan view. The display device 1 may include two longer sides extended in a first direction DR1, and two shorter sides extended in a second direction DR2 intersecting the first direction DR1. Although the corners where the longer sides and the shorter sides of the display device 1 meet may form a right angle, this is merely illustrative. The display device 1 may have rounded corners. According to another embodiment, the longer sides may be extended in the second direction DR2, and the shorter sides may be extended in the first direction DR1. The shape of the display device 1 in plan view is not limited to that shown in the drawings. The display device 1 may have a circular shape or other shapes.

In the drawings, the first direction DR1 and the second direction DR2 intersect each other as the horizontal directions. For example, the first direction DR1 and the second direction DR2 may be perpendicular to each other. A third direction DR3 may intersect the first direction DR1 and the second direction DR2, and may be a vertical direction, for example. Herein, the side indicated by the arrow of each of the first to third directions DR1, DR2 and DR3 may be referred to as a first side, while the opposite side may be referred to as an opposite side unless specifically state otherwise. As used herein, the terms "on," "upper side," "above," "top" and "upper surface" may refer to the side indicated by the arrow of the third direction DR3 as shown in the drawings. The terms "under," "lower side," "below," "bottom" and "lower surface" may refer to the opposite side indicated by the arrow of the third direction D3 as shown in the drawings.

The display device 1 may include a display area DA where images are displayed, and a non-display area NDA where no image may be displayed. According to an embodiment of the disclosure, the non-display area NDA may be disposed around the display area DA to surround it.

According to an embodiment, the display device 1 may include a display substrate 100, and a color conversion substrate 200 opposed to the display substrate 100, and may further include a sealing member 400 used to couple the display substrate 100 with the color conversion substrate 200, and a filler 300 used to fill between the display substrate 100 and the color conversion substrate 200.

The display substrate 100 may include elements and circuits for displaying images, e.g., a pixel circuit such as a switching element, a pixel-defining layer for defining an emission area and a non-emission area to be described later in the display area DA, and a self-luminous element. According to an embodiment, the self-light-emitting element may include at least one of an organic light-emitting diode, a quantum-dot light-emitting diode, an inorganic-based micro light-emitting diode (e.g., micro LED), and an inorganic-based nano light-emitting diode (e.g., nano LED). In the following description, an organic light-emitting diode will be described as an example of the self-light-emitting element for convenience of illustration.

The color conversion substrate 200 may be located on the display substrate 100 and may face the display substrate 100. According to an embodiment, the color conversion substrate 200 may include a color conversion pattern that converts the color of incident light. According to an embodiment, the color conversion pattern may include at least one of color filters and wavelength conversion patterns.

The sealing member 400 may be disposed between the display substrate 100 and the color conversion substrate 200 in the non-display area NDA. The sealing member 400 may be disposed along the edges of the display substrate 100 and the color conversion substrate 200 in the non-display area NDA to surround the display area DA in plan view. The display substrate 100 and the color conversion substrate 200 may be coupled to each other via the sealing member 400.

According to an embodiment, the sealing member 400 may be made of an organic material. For example, the sealing member 400 may be made of, but is not limited to, an epoxy resin.

The filler 300 may be located in the space between the display substrate 100 and the color conversion substrate 200 surrounded by the sealing member 400. The filler 300 may be used to fill the space between the display substrate 100 and the color conversion substrate 200.

According to an embodiment, the filler 300 may be made of a material that transmits light. According to an embodiment, the filler 300 may be made of an organic material. For example, the filler 300 may be made of, but is not limited to, a silicon-based organic material, an epoxy-based organic material, etc. In another embodiment, the filler 300 may be eliminated.

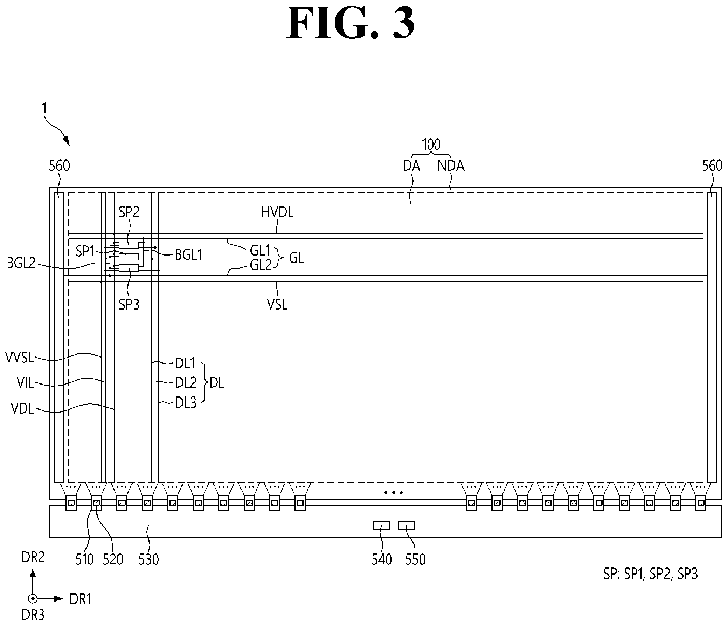

FIG. 3 is a schematic plan view showing the display substrate and other components according to an embodiment.

Referring to FIG. 3, the display device 1 may include a display substrate 100, flexible films 510, display drivers 520, a circuit board 530, a timing controller 540, a power supply unit 550, and a gate driver 560.

The display substrate 100 may have a rectangular shape in plan view. For example, the display substrate 100 may have a rectangular shape having longer sides in the first direction DR1 and shorter sides in the second direction DR2 in plan view. The corners where the longer sides in the first direction DR1 meet the shorter sides in the second direction DR2 may have a right angle or may be rounded with a predetermined or selected curvature. The shape of the display substrate 100 in plan view is not limited to a rectangular shape, but may be formed in a different polygonal shape, a circular shape, or an elliptical shape. For example, the display substrate 100 may be formed flat, but the disclosure is not limited thereto. For another example, the display substrate 100 may be formed to bend with a predetermined or selected curvature.

The display substrate 100 may include the display area DA and the non-display areas NDA.

The display area DA may display images therein and may be defined as a central area of the display substrate 100. The display area DA may include pixels SP, gate lines GL, data lines DL, initialization voltage lines VIL, first voltage lines VDL, horizontal voltage lines HVDL, vertical voltage lines VVSL, and second voltage lines VSL. The pixels SP may be formed in pixel areas that are intersections of the data lines DL and the gate lines GL, respectively. The pixels SP may include first to third pixels SP1, SP2 and SP3. Each of the first to third pixels SP1, SP2 and SP3 may be connected to one gate line GL and one data line DL. Each of the first to third pixels SP1, SP2 and SP3 may be defined as a minimum unit area that emits light.

Each of the first to third pixels SP1, SP2 and SP3 may include an organic light-emitting diode including an organic light-emitting layer, a quantum-dot light-emitting diode (LED) including a quantum-dot light-emitting layer, a micro LED, and/or an inorganic LED including an inorganic semiconductor.

The first pixel SP1 may emit light of a first color or red light, the second pixel SP2 may emit light of a second color or green light, and the third pixel SP3 may emit light of a third color or blue light. The pixel circuit of the second pixel SP2, the pixel circuit of the first pixel SP1 and the pixel circuit of the third pixel SP3 may be arranged in the direction opposite to the second direction DR2. It should be understood, however, that the disclosure is not limited thereto.

The gate lines GL may include a first gate line GL1 and a second gate line GL2. The first gate line GL1 may be extended in the first direction DR1. A plurality of first gate lines GL1 may be provided and may be spaced apart from one another in the second direction DR2. A first gate line GL1 may receive a first gate signal from the gate driver 560 and supply the first gate signal to a first auxiliary gate line BGL1. The first auxiliary gate line BGL1 may be extended from the first gate line GL1 to supply the first gate signal to the first to third pixels SP1, SP2 and SP3.

The second gate line GL2 may be extended in the first direction DR1. A plurality of second gate lines GL2 may be provided and may be spaced apart from one another in the second direction DR2. A second gate line GL2 may receive a second gate signal from the gate driver 560 and supply the second gate signal to a second auxiliary gate line BGL2. The second auxiliary gate line BGL2 may be extended from the second gate line GL2 to supply the second gate signal to the first to third pixels SP1, SP2 and SP3.

The data lines DL may be extended in the second direction DR2 and may be spaced apart from one another in the first direction DR1. The data lines DL may include first to third data lines DL1, DL2 and DL3. The first to third data lines DL1, DL2 and DL3 may supply data voltage to each of the first to third pixels SP1, SP2 and SP3.

The initialization voltage lines VIL may be extended in the second direction DR2 and may be spaced apart from one another in the first direction DR1. The initialization voltage lines VIL may supply the initialization voltage received from the display driver 520 to the pixel circuit of each of the first to third sub-pixels SP1, SP2 and SP3. The initialization voltage line VIL may receive a sensing signal from the pixel circuit of each of the first to third pixels SP1, SP2 and SP3 and may supply the sensing signal to the display drivers 520.

The first voltage lines VDL may be extended in the second direction DR2 and may be spaced apart from one another in the first direction DR1. The first voltage line VDL may supply a driving voltage or a high-level voltage received from the power supply 550 to the first to third pixels SP1, SP2 and SP3.

The horizontal voltage lines HVDL may be extended in the first direction DR1 and may be spaced apart from one another in the second direction DR2. The horizontal voltage lines HVDL may be connected to the first voltage lines VDL. The horizontal voltage lines HVDL may receive the driving voltage or high-level voltage from the first voltage lines VDL.

The vertical voltage lines VVSL may be extended in the second direction DR2 and may be spaced apart from one another in the first direction DR1. The vertical voltage lines VVSL may be connected to the second voltage lines VSL. A vertical voltage line VVSL may supply a low-level voltage received from the power supply 550 to a second voltage line VSL.

The second voltage lines VSL may be extended in the first direction DR1 and may be spaced apart from one another in the second direction DR2. The second voltage lines VSL may supply the low-level voltage to the first to third sub-pixels SP1, SP2 and SP3.

The connection relationships of the pixels SP, the gate lines GL, the data lines DL, the initialization voltage lines VIL, the first voltage lines VDL, the horizontal voltage lines HVDL, the vertical voltage lines VVSL and the second voltage lines VSL may be altered depending on the number and arrangement of the pixels SP.

The non-display area NDA may be defined as the remaining area of the display substrate 100 except the display area DA. For example, the non-display area NDA may include fan-out lines connecting the data lines DL, the initialization voltage lines VIL, the first voltage lines VDL and the vertical voltage line VVSL with the data drivers 520, a gate driver 560, and pads (not shown) connected to the flexible films 510.

The flexible films 510 may be connected to the pads disposed on the lower side of the non-display area NDA. The input terminals disposed on one side of the flexible films 510 may be attached to the circuit board 530 via a film attaching process, and the output terminals provided on the other side of the flexible films 510 may be attached to the pads via a film attaching process. For example, each of the flexible films 510 may be bent, like a tape carrier package and a chip on film. The flexible films 510 may be bent so that they are disposed under the display substrate 100 to reduce the bezel area of the display device 1.

The display drivers 520 may be mounted on the flexible films 510, respectively. For example, the display drivers 520 may be implemented as integrated circuits (IC). The display drivers 520 may receive digital video data and a data control signal from the timing controller 540, and may convert the digital video data into an analog data voltage in response to the data control signal to send it to the data lines DL through the fan-out lines.

The circuit board 530 may support the timing controller 540 and the power supply 550, and may provide signals and voltages to the display drivers 520. For example, the circuit board 530 may provide a signal provided from the timing controller 540 and supply voltages applied from the power supply unit 550 to the flexible films 510 and the data drivers 520 to drive the pixels to display images. To this end, signal lines and voltage lines may be disposed on the circuit board 530.

The timing controller 540 may be mounted on the circuit board 530 and may receive image data and a timing synchronization signal supplied from a display driving system or a graphic device through a user connector provided on the circuit board 530. The timing controller 540 may generate digital video data by coordinating the image data appropriately for the pixel arrangement structure in response to a timing synchronization signal, and may supply the generated digital video data to the display driver 520. The timing controller 540 may generate a data control signal and a gate control signal based on the timing synchronization signal. The timing controller 540 may control the timing of applying the data voltage of the display driver 520 based on the data control signal, and may control the timing of providing the gate signal of the gate driver 560 based on the gate control signal.

The power supply unit 550 may be disposed on the circuit board 530 to apply a supply voltage to the flexible films 510 and the display driver 520. For example, the power supply unit 550 may generate a driving voltage or a high-level voltage to supply it to the first voltage lines VDL, may generate a low-level voltage to supply it to the vertical voltage line VVSL, and may generate an initialization voltage to supply it to the initialization voltage lines.

The gate driver 560 may be disposed on the left side and the right side of the non-display area NDA. The gate driver 560 may generate a gate signal based on a gate control signal provided from the timing controller 540. The gate control signal may include, but is not limited to, a start signal, a clock signal, and a supply voltage. The gate driver 560 may provide gate signals to the gate lines GL in a predetermined or selected order.

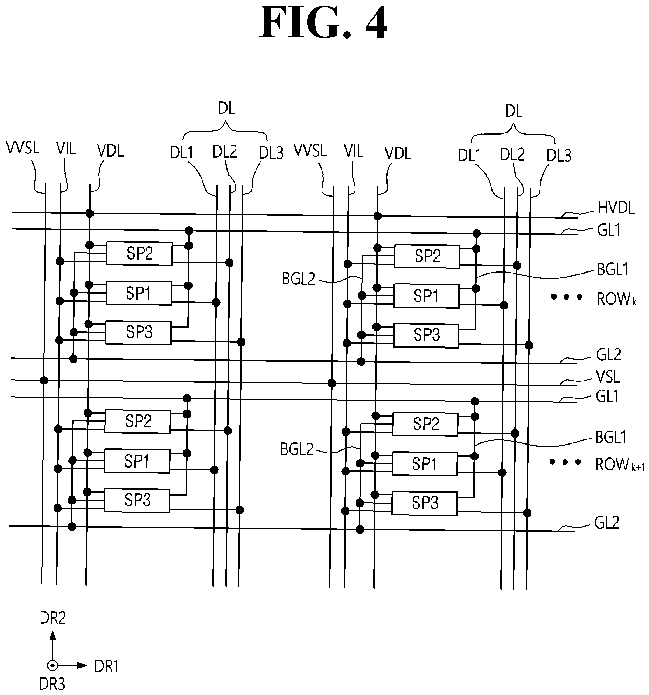

FIG. 4 is a schematic view showing pixels and lines of a display device according to an embodiment.

Referring to FIG. 4, a pixel SP may include first to third pixels SP1, SP2 and SP3. The pixel circuit of the second pixel SP2, the pixel circuit of the first pixel SP1 and the pixel circuit of the third pixel SP3 may be arranged in the direction opposite to the second direction DR2. It should be understood, however, that the disclosure is not limited thereto.

Each of the first to third sub-pixels SP1, SP2 and SP3 may be connected to the first voltage lines VDL, the initialization voltage lines VIL, the gate lines GL and the data lines DL.

The first voltage lines VDL may be extended in the second direction DR2. The first voltage lines VDL may be disposed on the left side of the pixel circuits of the first to third pixels SP1, SP2 and SP3. The first voltage lines VDL may supply a driving voltage or a high-level voltage to transistors of each of the first to third pixels SP1, SP2 and SP3.

The horizontal voltage lines HVDL may be extended in the first direction DR1. Each of the horizontal voltage lines HVDL may be disposed on the upper side of the first gate line GL1 disposed in the k^{th} row ROWₖ, where k is a positive integer. The horizontal voltage lines HVDL may be connected to the first voltage lines VDL. The horizontal voltage lines HVDL may receive the driving voltage or high-level voltage from the first voltage lines VDL.

The initialization voltage line VIL may be extended in the second direction DR2. The initialization voltage lines VIL may be disposed on the left side of the second auxiliary gate lines BGL2. The initialization voltage lines VIL may be disposed between the vertical voltage lines VVSL and the second auxiliary gate lines BGL2. The initialization voltage line VIL may apply the initialization voltage to the pixel circuit of each of the first to third pixels SP1, SP2 and SP3. The initialization voltage line VIL may receive a sensing signal from the pixel circuit of each of the first to third pixels SP1, SP2 and SP3 and may supply the sensing signal to the display drivers 520.

The vertical voltage lines VVSL may be extended in the second direction DR2. The vertical voltage lines VVSL may be disposed on the left side of the initialization voltage lines VIL. The vertical voltage lines VVSL may be connected between the power supply unit 550 and the second voltage lines VSL. The vertical voltage lines VVSL may provide the low-level voltage applied from the power supply unit 550 to the second voltage lines VSL.

The second voltage lines VSL may be extended in the first direction DR1. The second voltage line VSL may be disposed on the upper side of the first gate line GL1 disposed in the (k+1)^{th} row ROW₍ₖ₊₁₎. The second voltage lines VSL may supply the low-level voltage received from the vertical voltage lines VVSL to emission material layers of the first to third pixels SP1, SP2 and SP3.

The first gate lines GL1 may be extended in the first direction DR1. The first gate lines GL1 may be disposed on the upper side of the pixel circuit of the second pixels SP2. Each of the first gate lines GL1 may receive a first gate signal from the gate driver 560 and supply the first gate signal to the first auxiliary gate line BGL1. The first auxiliary gate lines BGL1 may be extended in the opposite direction to the second direction DR2 from the first gate lines GL1. Each of the first auxiliary gate lines BGL1 may be disposed on the right side of the pixel circuits of the first to third pixels SP1, SP2 and SP3. Each of the first auxiliary gate lines BGL1 may receive a first gate signal from the first gate line GL1 to supply the first gate signal to the first to third pixels SP1, SP2 and SP3.

The second gate lines GL2 may be extended in the first direction DR1. The second gate lines GL2 may be disposed on the lower side of the pixel circuit of the third pixels SP3. Each of the second gate lines GL2 may receive a second gate signal from the gate driver 560 and supply the second gate signal to the second auxiliary gate line BGL2. The second auxiliary gate lines BGL2 may be extended in the second direction DR2 from the second gate lines GL2. The second auxiliary gate lines BGL2 may be disposed on the left side of the first voltage lines VDL. Each of the second auxiliary gate lines BGL2 may receive a second gate signal from the second gate line GL2 to supply the second gate signal to the first to third pixels SP1, SP2 and SP3.

The data lines DL may be extended in the second direction DR2. The data lines DL may supply data voltages to the pixels SP. The data lines DL may include first to third data lines DL1, DL2 and DL3.

The first data line DL1 may be extended in the second direction DR2. The first data line DL1 may be disposed on the right side of the first auxiliary gate line BGL1. The first data line DL1 may supply the data voltage received from the display driver 520 to the pixel circuit of the first pixel SP1.

The second data line DL2 may be extended in the second direction DR2. The second data line DL2 may be disposed on the right side of the first data line DL1. The second data line DL2 may supply the data voltage received from the display driver 520 to the pixel circuit of the second pixel SP2.

The third data line DL3 may be extended in the second direction DR2. The third data line DL3 may be disposed on the right side of the second data line DL2. The third data line DL3 may supply the data voltage received from the display driver 520 to the pixel circuit of the third pixel SP3.

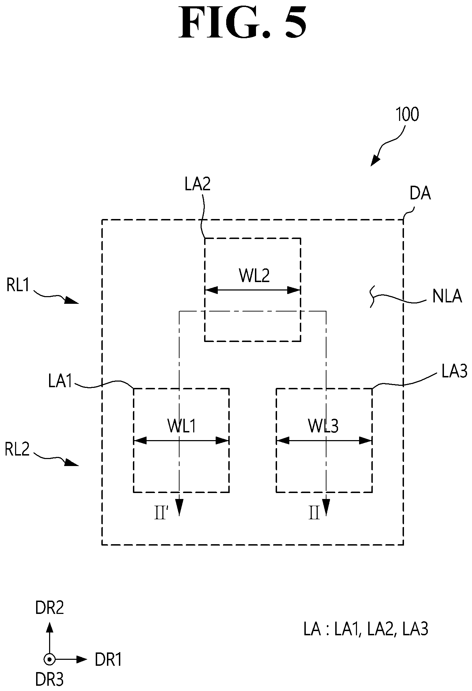

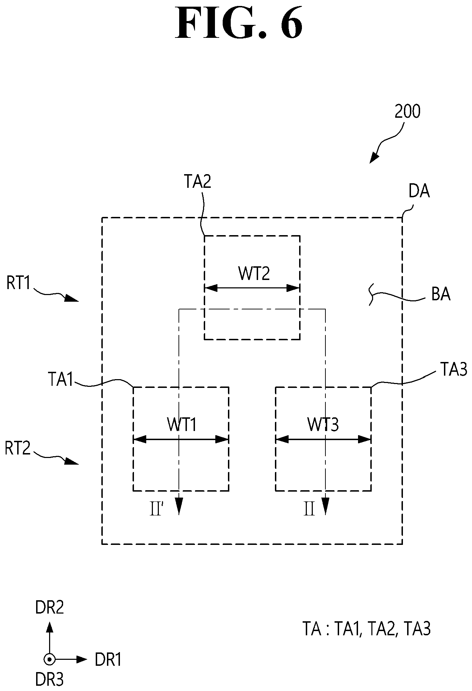

FIG. 5 is a schematic plan view showing the display area of the display substrate according to an embodiment. FIG. 6 is a schematic plan view showing the display area of the color conversion substrate according to an embodiment.

Referring to FIGS. 5 and 6 in conjunction with FIGS. 1 and 2, multiple light-emitting areas LA and a non-light-emitting area NLA may be defined in the display area DA of the display substrate 100. In the light-emitting areas LA, light generated in the light-emitting elements of the display substrate 100 may exit out of the display substrate 100. In the non-light-emitting area NLA, no light may exit out of the display substrate 100.

The light-emitting areas LA may include a first light-emitting area LA1, a second light-emitting area LA2, and a third light-emitting area LA3. In the display area DA of the display substrate 100, second light-emitting areas LA2 may be arranged in the first row RL1, and first light-emitting areas LA1 and third light-emitting areas LA3 may be arranged side-by-side in the first direction DR1 in the second row RL2. The first row RL1 and the second row RL2 may be adjacent to each other in the second direction DR2. It should be understood, however, that the disclosure is not limited thereto. The first light-emitting areas LA1, the second light-emitting areas LA2 and the third light-emitting areas LA3 may be arranged side-by-side in the first direction DR1 or the second direction DR2. The first light-emitting areas LA1 or the third light-emitting areas LA3 may be arranged in the first row RL1.

Lights emitted from the light-emitting areas LA of the display substrate 100 to the color conversion substrate 200 may be lights of the third color. According to an embodiment, the third color light may be blue light and may have a peak wavelength in the range of approximately 440 nm to approximately 480 nm. The peak wavelength may refer to the wavelength at which the intensity is maximum within a wavelength range. It should be understood, however, that the disclosure is not limited thereto. The lights emitted from the display substrate 100 to the color conversion substrate 200 in the light-emitting areas LA may be light in the ultraviolet region.

According to an embodiment, the first light-emitting area LA1 may have a predetermined or selected first width WL1 in the first direction DR1, the second light-emitting area LA2 may have a predetermined or selected second width WL2 in the first direction DR1, and the third light-emitting area LA3 may have a predetermined or selected third width WL3 in the first direction DR1. The first width WL1 of the first light-emitting area LA1 may be equal to the second width WL2 of the second light-emitting area LA2 and the third width WL3 of the third light-emitting area LA3. The area of the first light-emitting area LA1 may be equal to the area of the second light-emitting area LA2 and the area of the third light-emitting area LA3. It should be understood, however, that the disclosure is not limited thereto. The widths WL1, WL2 and WL3 and the areas of the light-emitting areas LA1, LA2 and LA3 may be different from one another.

According to an embodiment, the first light-emitting area LA1, the second light-emitting area LA2, and the third light-emitting area LA3 may have a square shape as shown in the drawings. It should be understood, however, that the disclosure is not limited thereto. The first light-emitting area LA1, the second light-emitting area LA2, and the third light-emitting area LA3 may have various shapes such as a rectangle, a diamond and a hexagonal shape.

The first light-emitting area LA1, the second light-emitting area LA2 and the third light-emitting area LA3 may form the first pixel SP1, the second pixel SP2 and the third pixel SP3, respectively. The first light-emitting area LA1, the second light-emitting area LA2 and the third light-emitting area LA3 may be repeatedly arranged along the first direction DR1 and the second direction DR2 throughout the display area DA.

The non-light-emitting area NLA may be located around the light-emitting areas LA of the display substrate 100 in the display area DA. The non-light-emitting area NLA may be disposed not only around the light-emitting areas LA but also between the first light-emitting area LA1 and the second light-emitting area LA2, between the second light-emitting area LA2 and the third light-emitting area LA3, and between the third light-emitting area LA3 and the first light-emitting area LA1.

Multiple light-transmitting areas TA and a light-blocking area BA may be defined in the display area DA of the color conversion substrate 200. In the light-transmitting areas, the light exiting from the display substrate 100 may be transmitted through the color conversion substrate 200 to be provided to the outside of the display device 1. In the light-blocking area BA, the light exiting from the display substrate 100 may not pass through it.

The light-transmitting areas TA may include a first light-transmitting area TA1, a second light-transmitting area TA2 and a third light-transmitting area TA3. In the display area DA of the color conversion substrate 200, second light-transmitting areas TA2 may be arranged in the first row RT1, and first light-transmitting areas TA1 and third light-transmitting areas TA3 may be arranged side-by-side in the second row RT2. It should be understood, however, that the disclosure is not limited thereto. The first light-transmitting areas TA1, the second light-transmitting areas TA2 and the third light-transmitting areas TA3 may be arranged side-by-side in the first direction DR1 or the second direction DR2. The first light-transmitting areas TA1 or the third light-transmitting areas TA3 may be arranged in the first row RT1.

The first light-transmitting area TA1 may have the size equal to the size of the first light-emitting area LA1 or may overlap the first light-emitting area LA1. Similarly to this, the second light-transmitting area TA2 may have the size equal to the size of the second emission area LA2 or may overlap the second emission area LA2, and the third light-transmitting area TA3 may have the size equal to the size of the third emission area LA3 or may overlap the third emission area LA3.

The light of the third color provided from the display substrate 100 may be transmitted through the first light-transmitting area TA1, the second light-transmitting area TA2 and the third light-transmitting area TA3 to exit out of the display device 1. Light exiting from the first light-transmitting area TA1 to the outside of the display device 1 is referred to as a first exit light. Light exiting from the second light-transmitting area TA2 to the outside of the display device 1 is referred to as a second exit light. Light exiting from the third light-transmitting area TA3 to the outside of the display device 1 is referred to as a third exit light. The first exit light may be light of the first color, the second exit light may be light of the second color, and the third exit light may be light of the third color. According to an embodiment, the light of the third color may be blue light having a peak wavelength in the range of approximately 440 nm to approximately 480 nm, and the light of the second color may be green light having a peak wavelength in the range of approximately 510 nm to approximately 550 nm. The light of the first color may be red light having a peak wavelength in the range of approximately 610 to approximately 650 nm. It should be understood, however, that the disclosure is not limited thereto. The light of the second color may be red light and the light of the first color may be green light.

According to an embodiment, the first light-transmitting area TA1 may have a predetermined or selected first width WT1 in the first direction DR1, the second light-transmitting area TA2 may have a predetermined or selected second width WT2 in the first direction DR1, and the third light-transmitting area TA3 may have a predetermined or selected third width WT3 in the first direction DR1. The first width WT1 of the first light-transmitting area TA1 may be equal to the second width WT2 of the second light-transmitting area TA2 and the third width WT3 of the third light-transmitting area TA3. The area of the first light-transmitting area TA1 may be equal to the area of the second light-transmitting area TA2 and the area of the third light-transmitting area TA3. It should be understood, however, that the disclosure is not limited thereto. The widths WT1, WT2 and WT3 and the areas of the light-transmitting areas TA1, TA2 and TA3 may be different from one another.

According to an embodiment, the first light-transmitting area TA1, the second light-transmitting area TA2, and the third light-transmitting area TA3 may have a square shape as shown in the drawings. It should be understood, however, that the disclosure is not limited thereto. They may have various shapes such as a rectangle, a diamond and a hexagonal shape.

The first light-transmitting area TA1, the second light-transmitting area TA2 and the third light-transmitting area TA3 may form the first pixel SP1, the second pixel SP2 and the third pixel SP3, respectively. The first light-transmitting area TA1, the second light-transmitting area TA2 and the third light-transmitting area TA3 may be repeatedly arranged along the first direction DR1 and the second direction DR2 throughout the display area DA.

The light-blocking area BA may be located around the light-transmitting areas TA of the color conversion substrate 200 in the display area DA. The light-blocking area BA may be disposed not only around the light-transmitting areas TA but also between the first light-transmitting area TA1 and the second light-transmitting area TA2, between the second light-transmitting area TA2 and the third light-transmitting area TA3, and between the third light-transmitting area TA3 and the first light-transmitting area TA1.

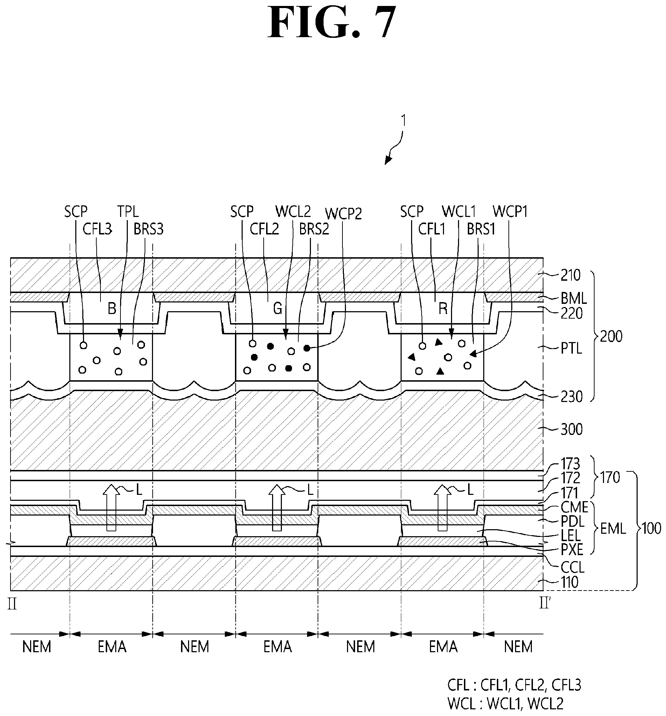

FIG. 7 is a schematic cross-sectional view of the display device, taken along line II - II' of FIG. 5 and 6.

Referring to FIG. 7, the display device 1 may include the display substrate 100, the color conversion substrate 200 facing the display substrate 100, and the filler 300 attaching them together.

The display substrate 100 may include a first substrate 110, a circuit layer CCL, an emission material layer EML, and an encapsulation structure 170.

The first substrate 110 may include a transparent material. For example, the first substrate 110 may include a transparent insulating material such as glass and/or quartz. The first substrate 110 may be a rigid substrate. However, the first substrate 110 is not limited to those described above. The first substrate 110 may include a plastic such as polyimide or may be flexible so that it can be curved, bent, folded and/or rolled.

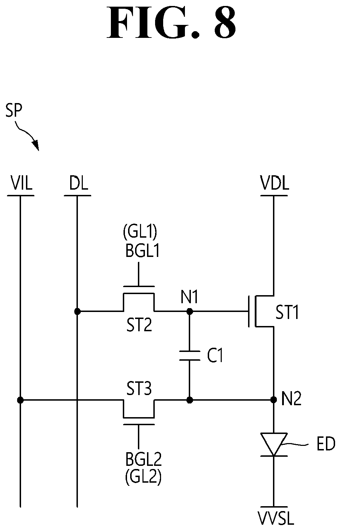

The circuit layer CCL (e.g., a thin-film transistor layer) may be disposed on the first substrate 110. The circuit layer CCL will be described in more detail later with reference to FIG. 8 and the like.

The emission material layer EML may be disposed on the circuit layer CCL. The emission material layer EML may include a pixel electrode PXE, a pixel-defining film PDL, a light-emitting element layer LEL, and a common electrode CME.

The pixel electrode PXE may be a first electrode, e.g., an anode electrode of a light-emitting diode. The pixel electrode PXE may have a stack structure of a material layer having a high work function such as indium-tin-oxide (ITO), indium-zinc-oxide (IZO), zinc oxide (ZnO) and/or indium oxide (In₂O₃), and/or a reflective material layer such as silver (Ag), magnesium (Mg), aluminium (Al), platinum (Pt), lead (Pd), gold (Au), nickel (Ni), neodymium (Nd), iridium (Ir), chromium (Cr), lithium (Li), calcium (Ca) and/or a mixture thereof. A material layer having a higher work function may be disposed on a higher layer than a reflective material layer so that it may be closer to the light-emitting layer LEL. The pixel electrode PXE may have, but is not limited to, a multilayer structure of ITO/Mg, ITO/MgF, ITO/Ag, and ITO/Ag/ITO.

The pixel-defining film PDL may be disposed on a surface of the first substrate 110 along the boundaries of the pixels SP. The pixel-defining film PDL may be disposed over the pixel electrode PXE, and may include an opening exposing the pixel electrodes PXE. The emission areas EMA and the non-emission area NEM may be distinguished by the pixel-defining layer PDL and the opening thereof. The pixel-defining film PDL may include an organic insulating material such as polyacrylate resin, epoxy resin, phenolic resin, polyamide resin, polyimide resin, unsaturated polyesters resin, poly phenylene ether resin, poly phenylene sulfide resin, and benzocyclobutene (BCB). The pixel-defining layer PDL may include an inorganic material.

The light-emitting layer LEL may be disposed on the pixel electrode PXE exposed by the pixel-defining film PDL. According to an embodiment where the display device 1 is an organic light-emitting display device, the light-emitting layer LEL may include an organic layer containing an organic material. The organic layer may include an organic, emissive layer and may further include at least one of a hole injection layer, a hole transport layer, an electron injection layer and an electronic transport layer as an auxiliary layer in some implementations to facilitate emission. In another embodiment where the display device 1 is a micro LED display device, a nano LED display device, etc., the light-emitting layer LEL may include an inorganic material such as an inorganic semiconductor.

In some embodiments, the light-emitting layer LEL may have a tandem structure including multiple organic emissive layers overlapping one another in the thickness direction and a charge generation layer disposed therebetween. The organic emissive layers overlapping one another may emit either light of the same wavelength or lights of different wavelengths. At least some of the light-emitting layers LEL of the pixels SP may be separated from or connected to the same layer of the adjacent pixel PX.

According to an embodiment, the light-emitting layers LEL of different color pixels SP may emit light of the same wavelength. For example, the light-emitting layer LEL of each color pixel SP may emit blue light or ultraviolet light, and a color control structure to be described later includes a wavelength conversion layer WCL, so that different pixels SP can display lights of different colors.

According to another embodiment of the disclosure, the light-emitting layers LEL of different color pixels SP may emit lights of different wavelengths. For example, the light-emitting layer LEL of a first pixel SP1 may emit light of the first color, the light-emitting layer LEL of a second pixel SP2 may emit light of the second color, and the light-emitting layer LEL of a third pixel SP3 may emit light of the third color.

The common electrode CME may be disposed on the light-emitting layer LEL. The common electrode CME may be in contact with the light-emitting layer LEL as well as the upper surface of the pixel-defining film PDL. The common electrode CME may be extended across the pixels SP. The common electrode CME may be disposed on the entire surface across the pixels SP. The common electrode CME may be a second electrode, i.e., a cathode electrode of the light-emitting diode. The common electrode CME may include a material layer having a small work function such as Li, Ca, LiF/Ca, LiF/Al, Al, Mg, Ag, Pt, Pd, Ni, Au, Nd, Ir, Cr, BaF and/or Ba, and/or a compound or mixture thereof (e.g., a mixture of Ag and Mg). The common electrode CME may further include a transparent metal oxide layer disposed on the material layer having a small work function.

The pixel electrode PXE, the light-emitting layer LEL and the common electrode CME may form a light-emitting element (e.g., an organic light-emitting element). Light emitted from the light-emitting layer LEL may pass through the common electrode CME to exit upwardly.

The encapsulation structure 170 may be disposed on the common electrode CME. The encapsulation structure 170 may include at least one thin-film encapsulation layer. For example, the encapsulation structure 170 may include a first inorganic film 171, a first organic film 172 and a second inorganic film 173.

The first inorganic film 171 may be disposed on the emission material layer EML. The first organic film 171 may include silicon nitride (SiNₓ), silicon oxide (SiOₓ), and/or silicon oxynitride (SiOₓN_{y}).

The organic film 172 may be disposed on the first inorganic film 171. The organic film 172 may include an organic insulating material such as polyacrylate resin, epoxy resin, phenolic resin, polyamide resin, polyimide resin, unsaturated polyesters resin, polyphenylene ether resin, polyphenylene sulfide resin, and/or benzocyclobutene (BCB).

The second inorganic film 173 may be disposed on the organic film 172. The second inorganic film 173 may contain the same material as the first inorganic film 171 described above. For example, the second inorganic film 173 may include silicon nitride (SiNₓ), silicon oxide (SiOₓ), and/or silicon oxynitride (SiOₓN_{y}).

The color conversion substrate 200 may be disposed on the encapsulation structure 170 to face it. The color conversion substrate 200 may include a second substrate 210, a light-blocking member BML, a color filter layer CFL, a first capping layer 220, partition walls or banks PTL, a wavelength conversion layer WCL, a transparent layer TPL, a second capping layer 230.

The second substrate 210 may include a transparent material. The second substrate 210 may include a transparent insulating material such as glass and/or quartz. The second substrate 210 may be a rigid substrate. However, the second substrate 210 is not limited to those described above. The second substrate 210 may include a plastic such as polyimide or may be flexible so that it can be curved, bent, folded and/or rolled.

The second substrate 210 may be of the same type as the first substrate 110 or may have different material, thickness, transmittance, etc. For example, the second substrate 210 may have a higher transmittance than the first substrate 110. The second substrate 210 may be either thicker or thinner than the first substrate 110.

The light-blocking member BML may be disposed along the boundary of the pixels SP on one surface of the second substrate 210 facing the first substrate 110. The light-blocking member BML may overlap the pixel-defining film PDL of the first display substrate 100 and may be disposed in the non-emission area NEM. The light-blocking member BML may include openings exposing a surface of the second substrate 210 overlapping the emission areas EMA. The light-blocking member BML may be formed in a lattice shape in plan view.

The light-blocking member BML may include an organic material. The light-blocking member BML can absorb external light, thereby reducing color distortion due to reflection of external light. The light-blocking member BML can prevent light emitted from the light-emitting layer LEL from intruding into adjacent pixels SP.

According to an embodiment of the disclosure, the light-blocking member BML can absorb all visible wavelengths. The light-blocking member BML may include a light-absorbing material. For example, the light-blocking member BML may be made of a material used as a black matrix of the display device 1.

According to another embodiment, the light-blocking member BML may absorb light in a particular wavelength range among the visible light wavelengths and may transmit light in other wavelength ranges. For example, the light-blocking member BML may include the same material as the color filter layers CFL. Specifically, the light-blocking member BML may be made of the same material as a blue color filter layer. In some embodiments, the light-blocking member BML may be formed integrally with the blue color filter layer. The light-blocking member BML may be eliminated.

The color filter layers CFL may be disposed on the surface of the second substrate 210 where the light-blocking member BML is disposed. The color filter layers CFL may be disposed on the surface of the second substrate 210 exposed through the opening of the light-blocking member BML. Furthermore, the color filter layers CFL may be partially disposed on the adjacent light-blocking member BML.

The color filter layers CFL may include a first color filter layer CFL1 disposed in the first pixel SP1, a second color filter layer CFL2 disposed in the second pixel SP2, and a third color filter layer CFL3 disposed in the third pixel SP3. Each of the color filter layers CFL may include a colorant such as a dye and a pigment which absorbs wavelengths other than the wavelength of the color it represents. The first color filter layer CFL1 may be a red color filter layer, the second color filter layer CFL2 may be a green color filter layer, and the third color filter layer CFL3 may be a blue color filter layer. Although the adjacent color filters CFL are spaced apart from one another on the light-blocking member BML in the example shown in the drawings, the disclosure is not limited thereto. The adjacent color filter layers CFL may partially overlap one another on the light-blocking member BML.

The first capping layer 220 may be disposed on the color filter layer CFL. The first capping layer 220 can prevent impurities such as moisture and air from permeating from the outside to damage or contaminate the color filter layer CFL. The first capping layer 220 can prevent the colorant of the color filter layer CFL from being diffused into other elements.

The first capping layer 220 may be in direct contact with a surface (lower surface in FIG. 7) of the color filter layers CFL. The first capping layer 220 may be made of an inorganic material. For example, the first capping layer 220 may be made of a material including silicon nitride, aluminium nitride, zirconium nitride, titanium nitride, hafnium nitride, tantalum nitride, silicon oxide, aluminium oxide, titanium oxide, tin oxide, silicon oxynitride, etc.

The banks PTL may be disposed on the first capping layer 220. The banks PTL may be disposed in the non-emission area NEM. The banks PTL may be disposed such that they overlap the light-blocking member BML. The banks PTL may include openings via which the color filter layers CFL are exposed. The banks PTL may include, but are not limited to, a photosensitive organic material. The banks PTL may further include a light-blocking material.

The wavelength conversion layer WCL and/or the transparent layer TPL may be disposed in the space exposed by the openings of the banks PTL. The wavelength conversion layer WCL and the transparent layer TPL may be formed by, but are not limited to, an inkjet process using the partition walls PTL as a bank.

According to an embodiment where the light-emitting layer LEL of each of the pixels SP emit light of a third color, the wavelength conversion layer WCL may include a first wavelength conversion pattern WCL1 disposed in the first pixel SP1, and a second wavelength conversion pattern WCL2 disposed in the second pixel SP2. The transparent layer TPL may be disposed in the third pixel SP3.

The first wavelength conversion pattern WCL1 may include a first base resin BRS 1, and first wavelength-converting particles WCP1 dispersed in the first base resin BRS1. The second wavelength conversion pattern WCL2 may include a second base resin BRS2 and second wavelength-converting particles WCP2 dispersed in the second base resin BRS2. The transparent layer TPL may include a third base resin BRS3 and scatterers SCP dispersed therein.

The first to third base resins BRS1, BRS2 and BRS3 may include a transparent organic material. For example, the first to third base resins BRS1, BRS2 and BRS3 may include an epoxy resin, an acrylic resin, a cardo resin, an imide resin, and/or the like. The first to third base resins BRS1, BRS2 and BRS3 may be made of, but are not limited to, the same material.

The scattering particles SCP may be metal oxide particles or organic particles. Examples of the metal oxide may include titanium oxide (TiO₂), zirconium oxide (ZrO₂), aluminium oxide (Al₂O₃), indium oxide (In₂O₃), zinc oxide (ZnO), tin oxide (SnO₂), etc. Examples of the material of the organic particles may include an acrylic resin, a urethane resin, etc.

The first wavelength-converting particles WCP1 may convert the third color into the first color, and the second wavelength-converting particles WCP2 may convert the third color into the second color. The first wavelength-converting particles WCP1 and the second wavelength-converting particles WCP2 may be quantum dots, quantum rods, phosphors, etc. The quantum dots may include Group IV nanocrystals, Group II - VI compound nanocrystals, Group III - V compound nanocrystals, Group IV - VI nanocrystals, or combinations thereof. The first wavelength conversion pattern WCL1 and the second wavelength conversion pattern WCL2 may further include scattering particles SCP that increase wavelength conversion efficiency.

The transparent layer TPL disposed in the third color pixel SP3 may transmit the light of the third color emitted from the light-emitting layer LEL without changing the wavelength. The scattering particles SCP of the transparent layer TPL may adjust a path of exiting light through the transparent layer TPL. The transparent layer TPL may include no wavelength conversion material.

The second capping layer 230 may be disposed on the wavelength conversion layer WCL, the transparent layer TPL and the banks PTL. The second capping layer 230 may be made of an inorganic material. The second capping layer 230 may include a material selected from among the materials listed above as materials of the first capping layer 220. The second capping layer 230 and the first capping layer 220 may be made of, but is not limited to, the same material.

The filler 300 may be disposed between the display substrate 100 and the color conversion substrate 200. The filler 300 may be used to fill the space between the display substrate 100 and the color conversion substrate 200 and to adhere and couple them together. The filler 300 may be disposed between the encapsulation structure 170 of the display substrate 100 and the second capping layer 230 of the color conversion substrate 200. The filler 300 may be made of, but is not limited to, a Si-based organic material, an epoxy-based organic material, etc.

FIG. 8 is a schematic diagram of an equivalent circuit of a pixel of a display device according to an embodiment of the disclosure.

Referring to FIG. 8, each of the pixels SP may be connected to a first voltage line VDL, a data line DL, an initialization voltage line VIL, a first gate line GL1, a second gate line GL2, and a vertical voltage line VVSL.

Each of the first to third pixels SP1, SP2 and SP3 may include a pixel circuit and a light-emitting element ED. The pixel circuit of each of the first to third pixels SP1, SP2 and SP3 may include first to third transistors ST1, ST2 and ST3, and a first capacitor C1.

The first transistor ST1 may include a gate electrode, a drain electrode, and a source electrode. The gate electrode of the first transistor ST1 may be connected to a first node N1, the drain electrode thereof may be connected to the first voltage line VDL, and the source electrode thereof may be connected to a second node N2. The first transistor ST1 may control a drain-source current (or a driving current) based on a data voltage applied to the gate electrode. The first transistor ST1 may be a driving transistor for driving the light-emitting element ED.

The light-emitting element ED may receive the driving current to emit light. The amount or the brightness of the light emitted from the light-emitting elements ED may be proportional to the magnitude of the driving current. The light-emitting element ED may be an organic light-emitting diode including an organic light-emitting layer, a quantum-dot LED including a quantum-dot light-emitting layer, a micro LED, and/or an inorganic LED including an inorganic semiconductor.

The first electrode of the light-emitting element ED may be connected to the second node N2, and a second electrode of the light-emitting element ED may be connected to the vertical voltage line VVSL. The first electrode of the light-emitting element ED may be connected to the source electrode of the first transistor ST1, the drain electrode of the third transistor ST3, and the second capacitor electrode of the first capacitor C1 through the second node N2.

The second transistor ST2 may be turned on by a first gate signal of the first gate line GL1 to electrically connect the data line DL with the first node N1, which is the gate electrode of the first transistor ST1. The second transistor ST2 may be turned on in response to the first gate signal to apply data voltage to the first node N1. The gate electrode of the second transistor ST2 may be connected to the first gate line GL1, the drain electrode thereof may be connected to the data line DL, and the source electrode thereof may be connected to the first node N1. The source electrode of the second transistor ST2 may be connected to the gate electrode of the first transistor ST1 and the first capacitor electrode of the first capacitor C1 through the first node N1. The second transistor ST2 may be a switching transistor that controls electric current flowing through the first transistor ST1 and the light-emitting element ED.

The third transistor ST3 may be turned on by a second gate signal of the second gate line GL2 to electrically connect the initialization voltage line VIL with the second node N2, which is the source electrode of the first transistor ST1. The third transistor ST3 may be turned on in response to the second gate signal to apply the initialization voltage to the second node N2. The third transistor ST3 may be turned on in response to the second gate signal to provide a sensing signal to the initialization voltage line VIL. The gate electrode of the third transistor ST3 may be connected to the second gate line GL2, the drain electrode may be connected to the second node N2, and the source electrode may be connected to the initialization voltage line VIL. The drain electrode of the third transistor ST3 may be connected to the source electrode of the first transistor ST1, the second capacitor electrode of the first capacitor C1, and the first electrodes of the first light-emitting element ED through the second node N2. The third transistor ST3 may be a switching transistor that controls electric current flowing through the first transistor ST1 and the light-emitting element ED.

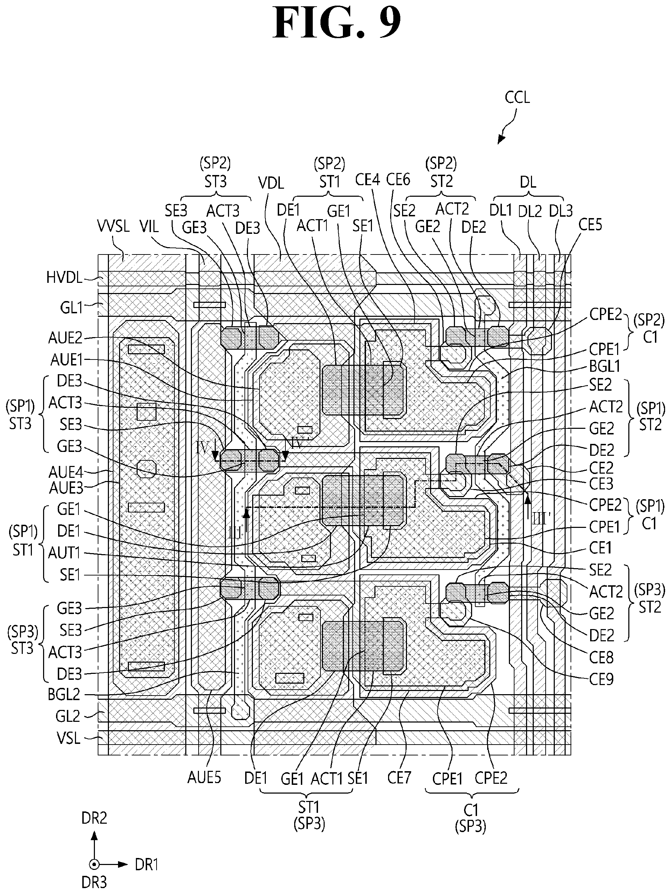

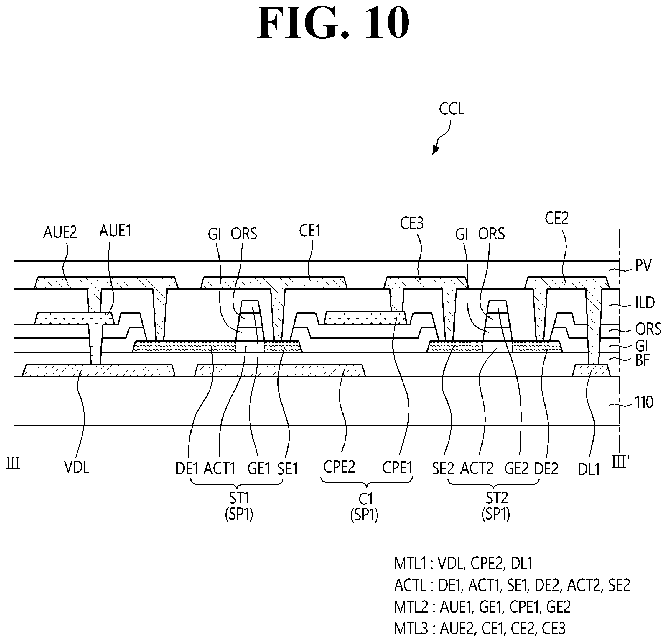

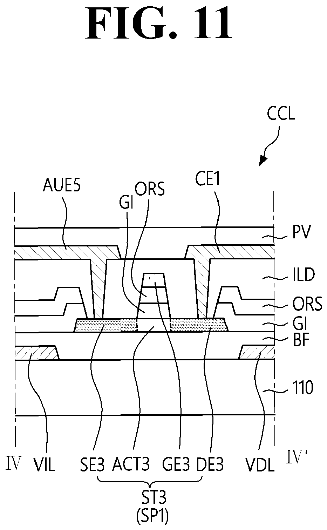

FIG. 9 is a schematic plan view showing the thin-film transistor layer of the display device according to an embodiment. FIG. 10 is a schematic cross-sectional view taken along line III - III' of FIG. 9. FIG. 11 is a schematic cross-sectional view taken along line IV - IV' of FIG. 9.

Referring to FIGS. 9 to 11, the circuit layer CCL (e.g., the thin-film transistor layer) may include first to third pixels SP1, SP2 and SP3, a first voltage line VDL, a horizontal voltage line HVDL, an initialization voltage line VIL, first and second gate lines GL1 and GL2, first and second auxiliary gate lines BGL1 and BGL2, data lines DL, a second voltage line VSL, and a vertical voltage line VVSL.

The circuit layer CCL may include a first metal layer MTL1 disposed on the first substrate 110; a buffer film BF covering the first metal layer MTL1; an active layer ACTL disposed on the buffer film BF; a gate insulating film GI covering the active layer ACTL; an oxygen-providing film ORS covering the gate insulating film GI; a second metal layer MTL2 disposed on the oxygen providing film ORS; an interlayer dielectric film ILD covering the second metal layer MTL2; a third metal layer MTL3 disposed on the interlayer dielectric film ILD; and a passivation film PV covering the third metal layer MTL3.

The pixels SP may include first to third pixels SP1, SP2 and SP3. The pixel circuit of the second pixel SP2, the pixel circuit of the first pixel SP1 and the pixel circuit of the third pixel SP3 may be arranged in the direction opposite to the second direction DR2. It should be understood, however, that the disclosure is not limited thereto.

The first voltage lines VDL may be disposed on the left side of the pixel circuits of the first to third pixels SP1, SP2 and SP3 in plan view. The first voltage line VDL may be disposed in the first metal layer MTL1 on the first substrate 110. The first voltage line VDL may overlap a first auxiliary electrode AUE1 of a second metal layer MTL2 and a second auxiliary electrode AUE2 of a third metal layer MTL3.

The first auxiliary electrode AUE1 may be connected to the first voltage line VDL. The second auxiliary electrode AUE2 may be connected to the first auxiliary electrode AUE1. The first voltage line VDL may be connected to the first and second auxiliary electrodes AUE1 and AUE2 to reduce line resistance.

The second auxiliary electrode AUE2 may be connected to a drain electrode DE1 of the first transistor ST1 of each of the first to third pixels SP1, SP2 and SP3. Accordingly, the first voltage line VDL may supply a driving voltage to the first to third pixels SP1, SP2 and SP3 through the second auxiliary electrode AUE2.

The horizontal voltage line HVDL may be disposed on the upper side of the first gate line GL1 in plan view. The horizontal voltage line HVDL may be disposed in the third metal layer MTL3. The horizontal voltage line HVDL may be connected to the first voltage line VDL to receive a driving voltage.

The initialization voltage line VIL may be disposed on the left side of the first voltage line VDL in plan view. The initialization voltage line VIL may be disposed in the first metal layer MTL. The initialization voltage line VIL may overlap a fifth auxiliary electrode AUE5 of the third metal layer MTL3 and may be connected to the fifth auxiliary electrode AUE5. The initialization voltage line VIL may be connected to the fifth auxiliary electrode AUE5 to reduce line resistance.

The fifth auxiliary electrode AUE5 may be connected to a source electrode SE3 of the third transistor ST3 of each of the first to third pixels SP1, SP2 and SP3. Accordingly, the initialization voltage line VIL may supply an initialization voltage to the third transistor ST3 of each of the first to third pixels SP1, SP2 and SP3 through the fifth auxiliary electrode AUE5, and may receive a sensing signal from the third transistor ST3.

The vertical voltage line VVSL may be disposed on the left side of the initialization voltage line VIL in plan view. The vertical voltage line VVSL may be disposed on the first metal layer MTL1. The vertical voltage line VVSL may overlap a third auxiliary electrode AUE3 of the second metal layer MTL2 and a fourth auxiliary electrode AUE4 of the third metal layer MTL3. The third auxiliary electrode AUE3 may be connected to the vertical voltage line VVSL, and the fourth auxiliary electrode AUE4 may be connected to the third auxiliary electrode AUE3. The vertical voltage line VVSL may be connected to the third and fourth auxiliary electrodes AUE3 and AUE4 to reduce line resistance. The vertical voltage line VVSL may be connected to the second voltage line VSL to provide a low-level voltage to the second voltage line VSL.

The second voltage line VSL may be disposed on the lower side of the second gate line GL2 in plan view. The second voltage line VSL may be disposed in the third metal layer MTL3. The second voltage line VSL may receive the low-level voltage from the vertical voltage line VSSL.

The first gate line GL1 may be disposed on the upper side of the pixel circuit of the second pixel SP2 in plan view. The first gate line GL1 may be disposed in the third metal layer MTL3. The first gate line GL1 may be connected to a first auxiliary gate line BGL1 and may provide the first gate signal received from the gate driver 560 to the first auxiliary gate line BGL1.

The first auxiliary gate line BGL1 may protrude from the first gate line GL1 in the opposite direction to the second direction DR2. The first auxiliary gate line BGL1 may be disposed on the right side of the pixel circuits of the first to third pixels SP1, SP2 and SP3 in plan view. The first auxiliary gate line BGL1 may be disposed in the second metal layer MTL2. The first auxiliary gate line BGL1 may provide the first gate signal received from the first gate line GL1 to the second transistor ST2 of each of the first to third pixels SP1, SP2 and SP3.

The second gate line GL2 may be disposed on the lower side of the pixel circuit of the third pixels SP3 in plan view. The second gate line GL2 may be disposed in the third metal layer MTL3. The second gate line GL2 may be connected to a second auxiliary gate line BGL2 and may provide the second gate signal received from the gate driver 560 to the second auxiliary gate line BGL2.

The second auxiliary gate line BGL2 may protrude from the second gate line GL2 in the second direction DR2 in plan view. The second auxiliary gate line BGL2 may be disposed between the initialization voltage line VIL and the first voltage line VDL in plan view. The second auxiliary gate line BGL2 may be disposed in the second metal layer MTL2. The second auxiliary gate line BGL2 may provide the second gate signal received from the second gate line GL2 to the third transistor ST3 of each of the first to third pixels SP1, SP2 and SP3.

The first data line DL1 may be disposed on the right side of the first auxiliary gate line BGL1 in plan view. The first data line DL1 may be disposed in the first metal layer MTL1. A second connection electrode CE2 of the third metal layer MTL3 may electrically connect the first data line DL1 with a drain electrode DE2 of the second transistor ST2 of the first pixel SP1. Accordingly, the first data line DL1 may supply a data voltage to the second transistor ST2 of the first pixel SP1 through the second connection electrode CE2.

The second data line DL2 may be disposed on the right side of the first data line DL1 in plan view. The second data line DL2 may be disposed on the first metal layer MTL1. A fifth connection electrode CE5 of the third metal layer MTL3 may electrically connect the second data line DL2 with the drain electrode DE2 of the second transistor ST2 of the second pixel SP2. Accordingly, the second data line DL2 may provide data voltage to the second transistor ST2 of the second pixel SP2 through the fifth connection electrode CE5.

The third data line DL3 may be disposed on the right side of the second data line DL2 in plan view. The third data line DL3 may be disposed on the first metal layer MTL1. An eighth connection electrode CE8 of the third metal layer MTL3 may electrically connect the third data line DL3 with the drain electrode DE2 of the second transistor ST2 of the third pixel SP3. Accordingly, the third data line DL3 may provide data voltage to the second transistor ST2 of the third pixel SP3 through the eighth connection electrode CE8.

The pixel circuit of the first pixel SP1 may include the first to third transistors ST1, ST2 and ST3. The first transistor ST1 of the first pixel SP1 may include an active area ACT1, a gate electrode GE1, a drain electrode DE1, and a source electrode SE1. The active area ACT1 of the first transistor ST1 may be disposed in the active layer ACTL, and may overlap the gate electrode GE1 of the first transistor ST1.

The gate electrode GE1 of the first transistor ST1 may be disposed in the second metal layer MTL2. The gate electrode GE1 of the first transistor ST1 may be a part of the first capacitor electrode CPE1 of the first capacitor C1.

The drain electrode DE1 and the source electrode SE1 of the first transistor ST1 may be formed into a conductor by heat-treating the active layer ACTL. The drain electrode DE1 and the source electrode SE1 may be made conductive as an n-type semiconductor, but the disclosure is not limited thereto. The drain electrode DE1 of the first transistor ST1 may be electrically connected to the first voltage line VDL through the second auxiliary electrode AUE2. The drain electrode DE1 of the first transistor ST1 may receive a driving voltage from the first voltage line VDL.

The source electrode SE1 of the first transistor ST1 may be connected to the first connection electrode CE1 of the third metal layer MTL3. The first connection electrode CE1 may be connected to a second capacitor electrode CPE2 of the first metal layer MTL1. Accordingly, the first capacitor C1 may be formed between the first capacitor electrode CPE1 and the second capacitor electrode CPE2 as well as between the first capacitor electrode CPE1 and the first connection electrode CE1.

Although not shown in the drawings, the first connection electrode CE1 may be electrically connected to the light-emitting element ED of the first pixel SP1. Accordingly, the first connection electrode CE1 may provide the driving current received from the pixel circuit of the first pixel SP1 to the light-emitting element ED.

The second transistor ST2 of the first pixel SP1 may include an active area ACT2, a gate electrode GE2, a drain electrode DE2 and a source electrode SE2. The active area ACT2 of the second transistor ST2 may be disposed in the active layer ACTL, and may overlap the gate electrode GE2 of the second transistor ST2.

The gate electrode GE2 of the second transistor ST2 may be disposed in the second metal layer MTL2. The gate electrode GE2 of the second transistor ST2 may be a part of the first auxiliary gate line BGL1.

The drain electrode DE2 and the source electrode SE2 of the second transistor ST2 may be formed into a conductor by heat-treating the active layer ACTL. The drain electrode DE2 of the second transistor ST2 may be electrically connected to the first data line DL1 through the second connection electrode CE2. Accordingly, the first data line DL1 may supply a data voltage to the second transistor ST2 of the first pixel SP1 through the second connection electrode CE2. The source electrode SE2 of the second transistor ST2 may be electrically connected to the first capacitor electrode CPE1 of the first capacitor C1 through a third connection electrode CE3 of the third metal layer MTL3.

The third transistor ST3 of the first pixel SP1 may include an active area ACT3, a gate electrode GE3, a drain electrode DE3 and a source electrode SE3. The active area ACT3 of the third transistor ST3 may be disposed in the active layer ACTL, and may overlap the gate electrode GE3 of the third transistor ST3.

The gate electrode GE3 of the third transistor ST3 may be disposed in the second metal layer MTL2. The gate electrode GE3 of the third transistor ST3 may be a part of the second auxiliary gate line BGL2.

The drain electrode DE3 and the source electrode SE3 of the third transistor ST3 may be formed into a conductor by heat-treating the active layer ACTL. The drain electrode DE3 of the third transistor ST3 may be connected to an extension of the first connection electrode CE1. The drain electrode DE3 of the third transistor ST3 may be electrically connected to the source electrode SE1 of the first transistor ST1 and the second capacitor electrode CPE2 of the first capacitor C1 through the first connection electrode CE1.

The source electrode SE3 of the third transistor ST3 may be electrically connected to the initialization voltage line VIL through the fifth auxiliary electrode AUE5. The source electrode SE3 of the third transistor ST3 may receive an initialization voltage from the initialization voltage line VIL. The source electrode SE3 of the third transistor ST3 may supply a sensing signal to the initialization voltage line VIL.

The pixel circuit of the second pixel SP2 may include the first to third transistors ST1, ST2 and ST3. The first transistor ST1 of the second pixel SP2 may include an active area ACT1, a gate electrode GE1, a drain electrode DE1, and a source electrode SE1. The active area ACT1 of the first transistor ST1 may be disposed in the active layer ACTL, and may overlap the gate electrode GE1 of the first transistor ST1.

The gate electrode GE1 of the first transistor ST1 may be disposed in the second metal layer MTL2. The gate electrode GE1 of the first transistor ST1 may be a part of the first capacitor electrode CPE1 of the first capacitor C 1.

The drain electrode DE1 and the source electrode SE1 of the first transistor ST1 may be formed into a conductor by heat-treating the active layer ACTL. The drain electrode DE1 and the source electrode SE1 may be made conductive as an n-type semiconductor, but the disclosure is not limited thereto. The drain electrode DE1 of the first transistor ST1 may be electrically connected to the first voltage line VDL through the second auxiliary electrode AUE2. The drain electrode DE1 of the first transistor ST1 may receive a driving voltage from the first voltage line VDL.

The source electrode SE1 of the first transistor ST1 may be connected to the fourth connection electrode CE4 of the third metal layer MTL3. The fourth connection electrode CE4 may be connected to the second capacitor electrode CPE2 of the first metal layer MTL1. Accordingly, the first capacitor C1 may be formed between the first capacitor electrode CPE1 and the second capacitor electrode CPE2 as well as between the first capacitor electrode CPE1 and the fourth connection electrode CE4.

Although not shown in the drawings, the fourth connection electrode CE4 may be electrically connected to the light-emitting element ED of the second pixel SP2. Accordingly, the fourth connection electrode CE4 may provide the driving current received from the pixel circuit of the second pixel SP2 to the light-emitting elements ED.

The second transistor ST2 of the second pixel SP2 may include an active area ACT2, a gate electrode GE2, a drain electrode DE2 and a source electrode SE2. The active area ACT2 of the second transistor ST2 may be disposed in the active layer ACTL, and may overlap the gate electrode GE2 of the second transistor ST2.

The gate electrode GE2 of the second transistor ST2 may be disposed in the second metal layer MTL2. The gate electrode GE2 of the second transistor ST2 may be a part of the first auxiliary gate line BGL1.

The drain electrode DE2 and the source electrode SE2 of the second transistor ST2 may be formed into a conductor by heat-treating the active layer ACTL. The drain electrode DE2 of the second transistor ST2 may be electrically connected to the second data line DL2 through the fifth connection electrode CE5. Accordingly, the second data line DL2 may supply a data voltage to the second transistor ST2 of the second pixel SP2 through the fifth connection electrode CE5. The source electrode SE2 of the second transistor ST2 may be electrically connected to the first capacitor electrode CPE1 of the first capacitor C1 through a sixth connection electrode CE6 of the third metal layer MTL3.

The third transistor ST3 of the second pixel SP2 may include the active area ACT3, the gate electrode GE3, the drain electrode DE3 and the source electrode SE3. The active area ACT3 of the third transistor ST3 may be disposed in the active layer ACTL, and may overlap the gate electrode GE3 of the third transistor ST3.

The gate electrode GE3 of the third transistor ST3 may be disposed in the second metal layer MTL2. The gate electrode GE3 of the third transistor ST3 may be a part of the second auxiliary gate line BGL2.

The drain electrode DE3 and the source electrode SE3 of the third transistor ST3 may be formed into a conductor by heat-treating the active layer ACTL. The drain electrode DE3 of the third transistor ST3 may be connected to an extension of the fourth connection electrode CE4. The drain electrode DE3 of the third transistor ST3 may be electrically connected to the source electrode SE1 of the first transistor ST1 and the second capacitor electrode CPE2 of the first capacitor C1 through the fourth connection electrode CE4.

The source electrode SE3 of the third transistor ST3 may be electrically connected to the initialization voltage line VIL through the fifth auxiliary electrode AUE5. The source electrode SE3 of the third transistor ST3 may receive an initialization voltage from the initialization voltage line VIL. The source electrode SE3 of the third transistor ST3 may supply a sensing signal to the initialization voltage line VIL.

The pixel circuit of the third pixel SP3 may include the first to third transistors ST1, ST2 and ST3. The first transistor ST1 of the third pixel SP3 may include the active area ACT1, the gate electrode GE1, the drain electrode DE1 and the source electrode SE1. The active area ACT1 of the first transistor ST1 may be disposed in the active layer ACTL, and may overlap the gate electrode GE1 of the first transistor ST1.

The gate electrode GE1 of the first transistor ST1 may be disposed in the second metal layer MTL2. The gate electrode GE1 of the first transistor ST1 may be a part of the first capacitor electrode CPE1 of the first capacitor C 1.

The drain electrode DE1 and the source electrode SE1 of the first transistor ST1 may be formed into a conductor by heat-treating the active layer ACTL. The drain electrode DE1 and the source electrode SE1 may be made conductive as an n-type semiconductor, but the disclosure is not limited thereto. The drain electrode DE1 of the first transistor ST1 may be electrically connected to the first voltage line VDL through the second auxiliary electrode AUE2. The drain electrode DE1 of the first transistor ST1 may receive a driving voltage from the first voltage line VDL.

The source electrode SE1 of the first transistor ST1 may be connected to a seventh connection electrode CE7 of the third metal layer MTL3. The seventh connection electrode CE7 may be connected to the second capacitor electrode CPE2 of the first metal layer MTL1. Accordingly, the first capacitor C1 may be formed between the first capacitor electrode CPE1 and the second capacitor electrode CPE2 as well as between the first capacitor electrode CPE1 and the seventh connection electrode CE7.

Although not shown in the drawings, the seventh connection electrode CE7 may be electrically connected to the light-emitting element ED of the third pixel SP3. Accordingly, the seventh connection electrode CE7 may provide the driving current received from the pixel circuit of the third pixel SP3 to the light-emitting element ED.

The second transistor ST2 of the third pixel SP3 may include the active area ACT2, the gate electrode GE2, the drain electrode DE2 and the source electrode SE2. The active area ACT2 of the second transistor ST2 may be disposed in the active layer ACTL, and may overlap the gate electrode GE2 of the second transistor ST2.

The gate electrode GE2 of the second transistor ST2 may be disposed in the second metal layer MTL2. The gate electrode GE2 of the second transistor ST2 may be a part of the first auxiliary gate line BGL1.

The drain electrode DE2 and the source electrode SE2 of the second transistor ST2 may be formed into a conductor by heat-treating the active layer ACTL. The drain electrode DE2 of the second transistor ST2 may be electrically connected to the third data line DL3 through the eighth connection electrode CE8. Accordingly, the third data line DL3 may supply a data voltage to the second transistor ST2 of the third pixel SP3 through the eighth connection electrode CE8. The source electrode SE2 of the second transistor ST2 may be electrically connected to the first capacitor electrode CPE1 of the first capacitor C1 through a ninth connection electrode CE9 of the third metal layer MTL3.

The third transistor ST3 of the third pixel SP3 may include the active area ACT3, the gate electrode GE3, the drain electrode DE3 and the source electrode SE3. The active area ACT3 of the third transistor ST3 may be disposed in the active layer ACTL, and may overlap the gate electrode GE3 of the third transistor ST3.

The gate electrode GE3 of the third transistor ST3 may be disposed in the second metal layer MTL2. The gate electrode GE3 of the third transistor ST3 may be a part of the second auxiliary gate line BGL2.

The drain electrode DE3 and the source electrode SE3 of the third transistor ST3 may be formed into a conductor by heat-treating the active layer ACTL. The drain electrode DE3 of the third transistor ST3 may be connected to a second extension of the seventh connection electrode CE7. The drain electrode DE3 of the third transistor ST3 may be electrically connected to the source electrode SE1 of the first transistor ST1 and the second capacitor electrode CPE2 of the first capacitor C1 through the seventh connection electrode CE7.

The source electrode SE3 of the third transistor ST3 may be electrically connected to the initialization voltage line VIL through the fifth auxiliary electrode AUE5. The source electrode SE3 of the third transistor ST3 may receive an initialization voltage from the initialization voltage line VIL. The source electrode SE3 of the third transistor ST3 may supply a sensing signal to the initialization voltage line VIL.

Referring to FIGS. 10 and 11, the first to third transistors ST1, ST2 and ST3 of each of the first to third pixels SP1, SP2 and SP3 may include drain electrodes DE1, DE2 and DE3, active areas ACT1, ACT2 and ACT3, source electrodes SE1, SE2 and SE3, a gate insulating film GI, an oxygen-providing film ORS, and gate electrodes GE1, GE2 and GE3.

Since the first to third transistors ST1, ST2 and ST3 may have similar structures, the first transistor ST1 will be described for convenience of illustration.

The active area ACT1, the drain electrode DE1 and the source electrode SE1 of the first transistor ST1 may be disposed in the active layer ACTL. The active layer ACTL may include at least one of: ITGZO (InSnGaZnO)-based, ITGO (InSnGaO)-based, and IGO (InGaO)-based oxide semiconductor materials. ITGZO (InSnGaZnO)-based, ITGO (InSnGaO)-based, and IGO (InGaO)-based oxide semiconductors may have higher electron mobility than IGZO (InGaZnO)-based oxide semiconductors.

The gate insulating film GI may be formed over the entire surface of the active layer ACTL except for some etched portions. In the first transistor ST1, the gate insulating film GI may overlap the active area ACT1 in the third direction DR3. The gate insulating film GI may be in direct contact with the active area ACT 1. In the first transistor ST1, the gate insulating film GI may include contact holes to expose at least a part of the source electrode SE1 and the drain electrode DE1. The gate insulating film GI may include at least one of silicon oxide (SiOₓ), silicon nitride (SiNₓ), and silicon oxynitride (SiOₓN_{y}).

The oxygen-providing film ORS may be formed over the entire surface of the gate insulating film GI except for some etched portions. In the first transistor ST1, the oxygen-providing film ORS may overlap the active area ACT1 and the gate insulating film GI in the third direction DR3. The oxygen-providing film ORS may be in direct contact with the gate insulating film GI. In the first transistor ST1, the oxygen-providing film ORS may include contact holes to expose at least a part of the source electrode SE1 and the drain electrode DE1. The oxygen-providing film ORS may include at least one of silicon oxide (SiOₓ) and silicon oxynitride (SiOₓN_{y}).

The gate electrode GE1 of the first transistor ST1 may be disposed in the second metal layer MTL2 disposed on the oxygen-providing film ORS. The gate electrode GE1 of the first transistor ST1 may overlap the active region ACT1 of the first transistor ST1, the gate insulating film GI, and the oxygen-providing film ORS in the third direction DR3.

The active area ACT2, the drain electrode DE2 and the source electrode SE2 of the second transistor ST2 may be disposed in the active layer ACTL. The active layer ACTL may include at least one of: ITGZO (InSnGaZnO)-based, ITGO (InSnGaO)-based, and IGO (InGaO)-based oxide semiconductor materials. ITGZO (InSnGaZnO)-based, ITGO (InSnGaO)-based, and IGO (InGaO)-based oxide semiconductors may have higher electron mobility than IGZO (InGaZnO)-based oxide semiconductors.

The gate insulating film GI may be formed over the entire surface of the active layer ACTL except for some etched portions. In the second transistor ST2, the gate insulating film GI may overlap the active area ACT2 in the third direction DR3. The gate insulating film GI may be in direct contact with the active area ACT2. In the second transistor ST2, the gate insulating film GI may include contact holes to expose at least a part of the source electrode SE2 and the drain electrode DE2. The gate insulating film GI may include at least one of silicon oxide (SiOₓ), silicon nitride (SiNₓ), and silicon oxynitride (SiOₓN_{y}).

The oxygen-providing film ORS may be formed over the entire surface of the gate insulating film GI except for some etched portions. In the second transistor ST2, the oxygen-providing film ORS may overlap the active area ACT2 and the gate insulating film GI in the third direction DR3. The oxygen-providing film ORS may be in direct contact with the gate insulating film GI. In the second transistor ST2, the oxygen-providing film ORS may include contact holes to expose at least a part of the source electrode SE2 and the drain electrode DE2. The oxygen-providing film ORS may include at least one of silicon oxide (SiOₓ) and silicon oxynitride (SiOₓN_{y}).

The gate electrode GE2 of the second transistor ST2 may be disposed in the second metal layer MTL2 disposed on the oxygen-providing film ORS. The gate electrode GE2 of the second transistor ST2 may overlap the active region ACT2, the gate insulating film GI, and the oxygen-providing film ORS in the third direction DR3.

The active area ACT3, the drain electrode DE3 and the source electrode SE3 of the third transistor ST3 may be disposed in the active layer ACTL. The active layer ACTL may include at least one of: ITGZO (InSnGaZnO)-based, ITGO (InSnGaO)-based, and IGO (InGaO)-based oxide semiconductor materials. ITGZO (InSnGaZnO)-based, ITGO (InSnGaO)-based, and IGO (InGaO)-based oxide semiconductors may have higher electron mobility than IGZO (InGaZnO)-based oxide semiconductors.

The gate insulating film GI may be formed over the entire surface of the active layer ACTL except for some etched portions. In the third transistor ST3, the gate insulating film GI may overlap the active area ACT3 in the third direction DR3. The gate insulating film GI may be in direct contact with the active area ACT3. In the third transistor ST3, the gate insulating film GI may include contact holes to expose at least a part of the source electrode SE3 and the drain electrode DE3. The gate insulating film GI may include at least one of silicon oxide (SiOₓ), silicon nitride (SiNₓ), and silicon oxynitride (SiOₓN_{y}).

The oxygen-providing film ORS may be formed over the entire surface of the gate insulating film GI except for some etched portions. In the third transistor ST3, the oxygen-providing film ORS may overlap the active area ACT3 and the gate insulating film GI in the third direction DR3. The oxygen-providing film ORS may be in direct contact with the gate insulating film GI. In the third transistor ST3, the oxygen-providing film ORS may include contact holes to expose at least a part of the source electrode SE3 and the drain electrode DE3. The oxygen-providing film ORS may include at least one of silicon oxide (SiOₓ) and silicon oxynitride (SiOₓN_{y}).

The gate electrode GE3 of the third transistor ST3 may be disposed in the second metal layer MTL2 disposed on the oxygen-providing film ORS. The gate electrode GE3 of the third transistor ST3 may overlap the active area ACT3, the gate insulating film GI, and the oxygen-providing film ORS in the third direction DR3.

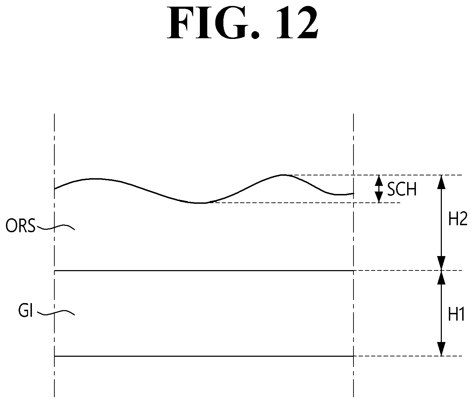

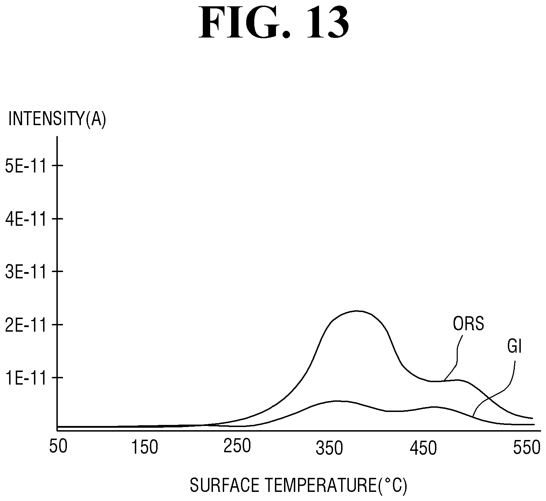

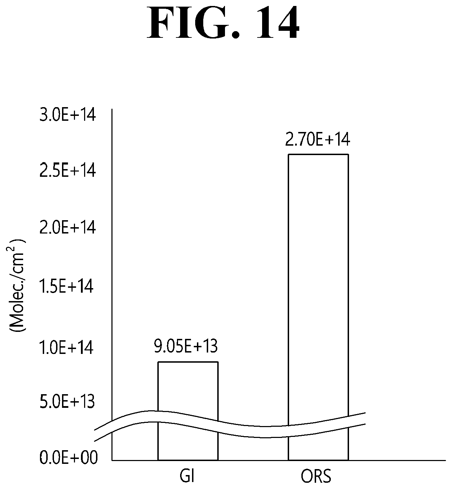

FIG. 12 is a schematic cross-sectional view showing a gate insulating film and an oxygen-providing film. FIG. 13 is a schematic graph for comparing the amount of oxygen releasable from a gate insulating film with the amount of oxygen releasable from an oxygen-providing film versus the temperature according to an embodiment. FIG. 14 is a schematic graph for comparing the total amount of oxygen releasable from the gate insulating film with the total amount of oxygen releasable from the oxygen-providing film according to an embodiment.

FIG. 13 is a graph showing the amount of released oxygen versus the surface temperature according to the TDS (Thermal Desorption Spectroscopy), and FIG. 14 is a graph for showing the total amount of released oxygen obtained by integrating the graph of FIG. 13.

Since the first to third transistors ST1, ST2 and ST3 may have similar structures according to an embodiment, the first transistor ST1 will be described for convenience of illustration.

Referring to FIGS. 12 to 14 in conjunction with FIGS. 10 and 11, in the display device 1 according to an embodiment, the oxygen-providing film ORS may be disposed on the gate insulating film GI of the first transistor ST1, so that oxygen flows into the active area ACT1 from the oxygen-providing film ORS through the gate insulating film GI, thereby improving the reliability of the semiconductor characteristics of the active area ACT1 of the first transistor ST1.

More specifically, the active layer ACTL of the first transistor ST1 may include an oxide semiconductor, especially an ITGZO (InSnGaZnO)-based, ITGO (InSnGaO)-based, or IGO (InGaO)-based oxide semiconductor. In some embodiments, the gate insulating film GI and the oxygen-providing film ORS disposed over the active layer ACTL may include silicon oxide (SiOₓ).

The ITGZO (InSnGaZnO)-based, ITGO (InSnGaO)-based, and IGO (InGaO)-based oxide semiconductors may comprise oxygen vacancies. The ITGZO (InSnGaZnO)-based, ITGO (InSnGaO)-based, and IGO (InGaO)-based oxide semiconductors may include a greater number of oxygen vacancies than IGZO (InGaZnO)-based oxide semiconductors. The active layer ACTL of the first transistor ST1 may include a greater number of oxygen vacancies and accordingly may have higher electron mobility.

However, since some of the oxygen vacancies have an unstable energy state, some of them may be filled with oxygen again during subsequent processes of depositing overlying layers of the active layer ACTL. For this reason, in existing display devices, the semiconductor characteristics of the active layer ACTL may change, resulting in reliability issues in semiconductor devices.

In contrast, in the display device 1 according to an embodiment, by disposing the oxygen-providing film ORS having a greater amount of releasable oxygen on the active area ACT1, oxygen vacancies having an unstable energy state may be filled with oxygen in advance, to suppress changes in characteristics of the semiconductor devices, and thus the reliability of the semiconductor devices can be improved.

For example, the amount of oxygen releasable from the oxygen-providing film ORS may be greater than the amount of oxygen releasable from the gate insulating film GI. In the graph shown in FIG. 13, the amount of releasable oxygen is shown under the conditions of rising-temperature velocity of about 60 °C/min and the temperature range of about 50°C to about 1,200°C using the TDS.

In the graph of FIG. 13, the x-axis represents the surface temperature of the analysis target instead of the internal temperature of a TDS device. In the graph of FIG. 13, the y-axis represents the intensity of an electrical signal generated by detecting the amount of released oxygen molecules by a detector of the TDS device. It can be interpreted that the greater the intensity of the electric signal generated by the detector is, the greater the amount of released oxygen is.

It can be seen from the graph of FIG. 13 that the amount of oxygen released from the oxygen-providing film ORS is greater than that of the gate insulating film GI in most of the temperature range.

In particular, the graph shown in FIG. 14 represents the total amounts of oxygen released from the gate insulating film and the oxygen-providing film by converting the graph of FIG. 13. For example, as shown in the graph shown in FIG. 14, under the same conditions as the graph of FIG. 13, the total amount of oxygen released from the oxygen-providing film ORS may be approximately 2.70 × 10¹⁴ molecules/cm², and the total amount of oxygen released from the gate insulating film GI may be approximately 9.05×10¹³ molecules/cm². That is to say, the amount of oxygen releasable from the oxygen-providing film ORS may be about three times or more the amount of oxygen releasable from the gate insulating film GI. In an embodiment, the total amount of oxygen releasable from the oxygen-providing film may be about 2.5×10¹⁴ molecules/cm² or more. In case that the total amount of oxygen releasable from the oxygen-providing film is about 2.5×10¹⁴ molecules/cm² or more, the amount of oxygen flowing into the active area ACT1 through the gate insulating film GI is sufficient, thereby improving the reliability of the characteristics of the semiconductor device in the active area ACT1.

Incidentally, the oxygen-providing film ORS may be in direct contact with the gate insulating film GI, and the gate insulating film GI may be in direct contact with the active area ACT1. The oxygen-providing film ORS may be spaced apart from the active area ACT1 with the gate insulating film GI interposed therebetween.

In case that the oxygen-providing film ORS and the gate insulating film GI contain silicon oxide (SiOₓ), the O/Si ratio of the oxygen-providing film ORS may be greater than the O/Si ratio of the gate insulating film GI. For example, the O/Si ratio of the oxygen-providing film ORS may be equal to or greater than about 1.83, and the O/Si ratio of the gate insulating film GI may be less than about 1.83.

As described above, the oxygen-providing film ORS having a higher oxygen content may not be disposed directly on the active area ACT1 but the gate insulating film GI having a lower oxygen content may be disposed between the oxygen-providing film ORS and the active area ACT1. As a result, it may be possible to prevent excessive injection of oxygen into the active area ACT1. Accordingly, more oxygen vacancies can be ensured compared to the structure in which the oxygen-providing film ORS is disposed directly on the active area ACT1, and thus it may be possible to achieve high electron mobility in the active area ACT1.

Incidentally, as shown in FIG. 12, the thickness H2 of the oxygen-providing film ORS may be greater than the thickness H1 of the gate insulating film GI. For example, the thickness H2 of the oxygen-providing film ORS may be two to five times the thickness H1 of the gate insulating film GI. The thickness H2 of the oxygen-providing film ORS may range from about 20 nm to about 50 nm, and the thickness of the gate insulating film GI may range from about 10 nm to about 15 nm.

The oxygen-providing film ORS may include depressions and elevations on its surface. The maximum height difference SCH between the depressions and elevations may be less than approximately 2 nm. The maximum height difference SCH between the depressions and elevations may mean the height difference between the highest elevation and the lowest elevation. By reducing roughness of the oxygen-providing film ORS to improve film quality, it may be possible to achieve the reliability of the amount of oxygen flowing from the oxygen-providing film ORS into the active area ACT1.

Hereinafter, a display device according to another embodiment of the disclosure will be described. In the following description, the same or similar elements will be denoted by the same or similar reference numerals, and redundant descriptions will be omitted or briefly described.

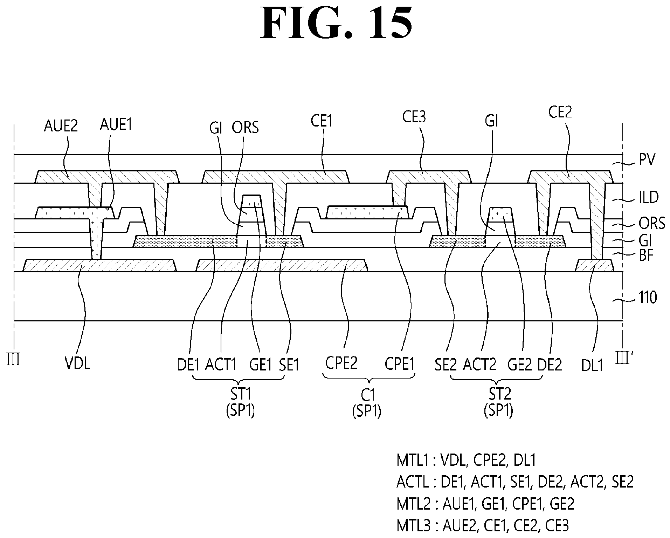

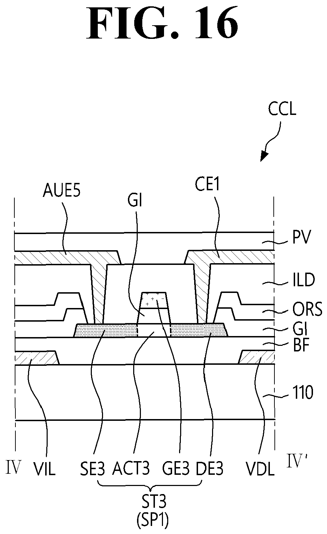

FIG. 15 is a schematic cross-sectional view of a display device according to another embodiment of the disclosure. FIG. 16 is a schematic cross-sectional view of a display device according to another embodiment of the disclosure.

A display device according to an embodiment of FIGS. 15 and 16 may be different from the display device according to an embodiment of FIG. 10 and the like at least in that a second transistor ST2 and a third transistor ST3 may include no oxygen-providing film ORS.

More specifically, the first to third transistors ST1, ST2 and ST3 of each of the first to third pixels SP1, SP2 and SP3 may include drain electrodes DE1, DE2 and DE3, active areas ACT1, ACT2 and ACT3, and source electrodes SE1, SE2 and SE3, a gate insulating film GI, and gate electrodes GE1, GE2, and GE3.

Since the first to third transistors ST1, ST2 and ST3 may have similar structures, the first transistor ST1 will be described for convenience of illustration.

The first transistor ST1 may include an oxygen-providing film ORS whereas the second and third transistors ST2 and ST3 may include no oxygen-providing film ORS.

The oxygen-providing film ORS may be formed over the entire surface of the gate insulating film GI except for some etched portions. In the first transistor ST1, the oxygen-providing film ORS may overlap the active area ACT1 and the gate insulating film GI in the third direction DR3. The oxygen-providing film ORS may be in direct contact with the gate insulating film GI. In the first transistor ST1, the oxygen-providing film ORS may include a contact hole to expose at least a part of the source electrode SE1 and the drain electrode DE1.

On the other hand, the oxygen-providing film ORS may not be disposed where it overlaps the active areas ACT2 and ACT3 in the second and third transistors ST2 and ST3. In the second and third transistors ST2 and ST3, the oxygen-providing film ORS may include contact holes to expose at least a part of the source electrodes SE2 and SE3 and the drain electrodes DE2 and DE3. To this end, in the second and third transistors ST2 and ST3, the parts of the oxygen-providing film ORS in line with the active areas ACT2 and ACT3 may be etched and removed together. Accordingly, in the second transistor ST2 and the third transistor ST3, the gate electrodes GE2 and GE3 may be disposed directly on the gate insulating film GI.

As shown in FIGS. 15 and 16, in the display device 1 according to an embodiment, among the first to third transistors ST1, ST2 and ST3, only the first transistor ST1 may include the oxygen-providing film ORS while the second and third transistors ST2 and ST3 may not include the oxygen-providing film ORS. It should be understood, however, that this is merely illustrative. According to several other embodiments, the second transistor ST2 may include the oxygen-providing film ORS while the first and third transistors ST1 and ST3 may not include the oxygen-providing film ORS, or the third transistor ST3 may include the oxygen-providing film ORS while the first and second transistors ST1 and ST2 may not include the oxygen-providing film ORS. In other embodiments, the first transistor ST1 may not include the oxygen-providing film ORS while the second and third transistors ST2 and ST3 may include the oxygen-providing film ORS, the second transistor ST2 may not include the oxygen-providing film ORS while the first and third transistors ST1 and ST3 may include the oxygen-providing film ORS, or the third transistor ST3 may not include the oxygen-providing film ORS while the first and second transistors ST1 and ST2 may include the oxygen-providing film ORS.

Hereinafter, a method of fabricating a display device according to an embodiment of the disclosure will be described.

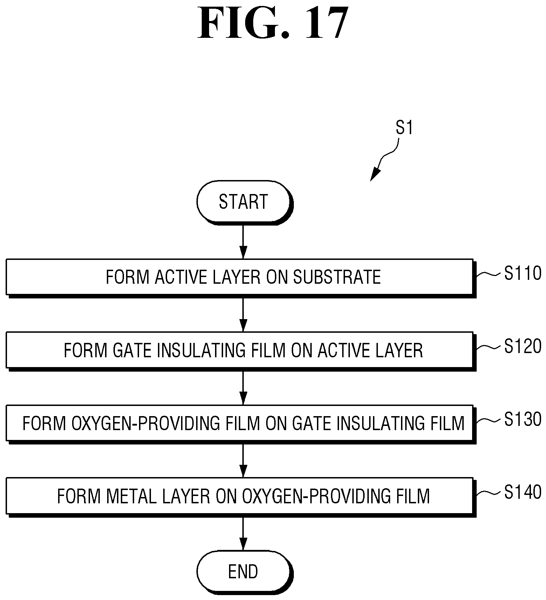

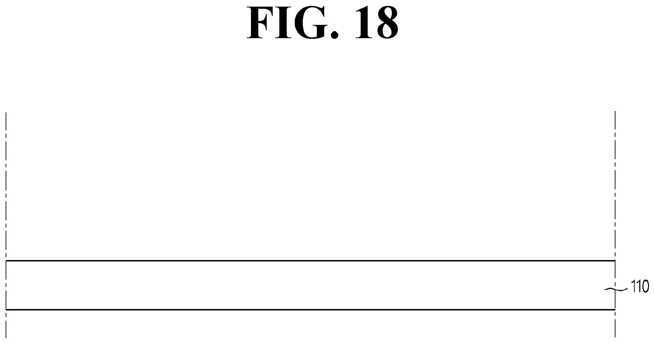

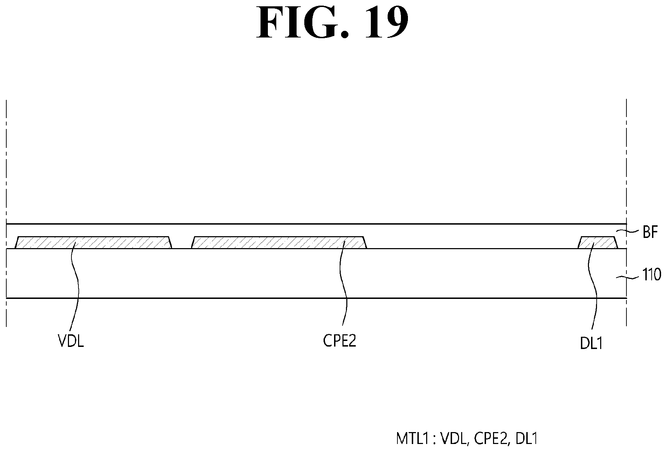

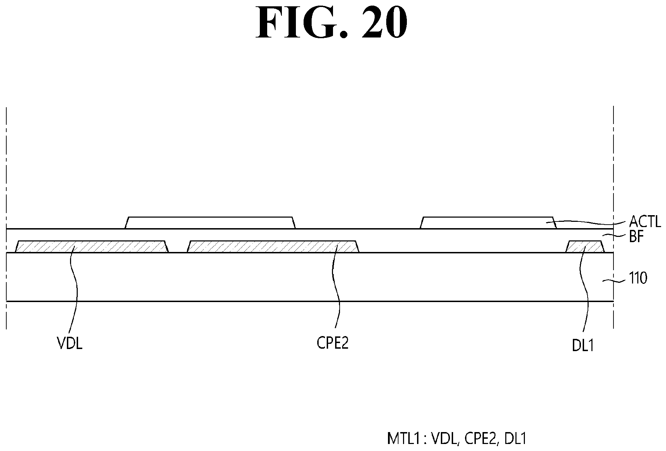

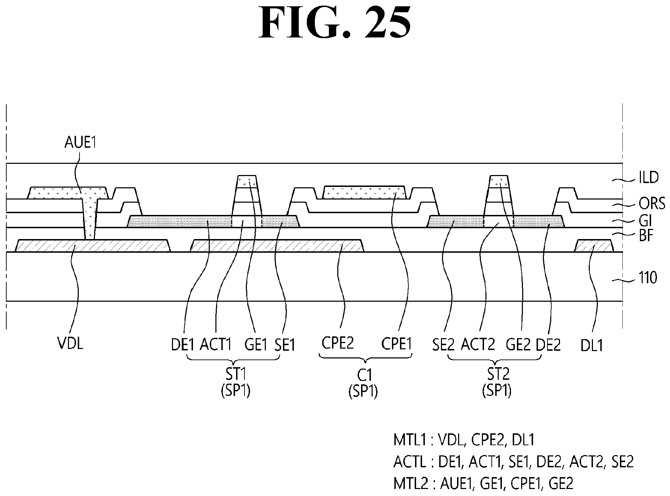

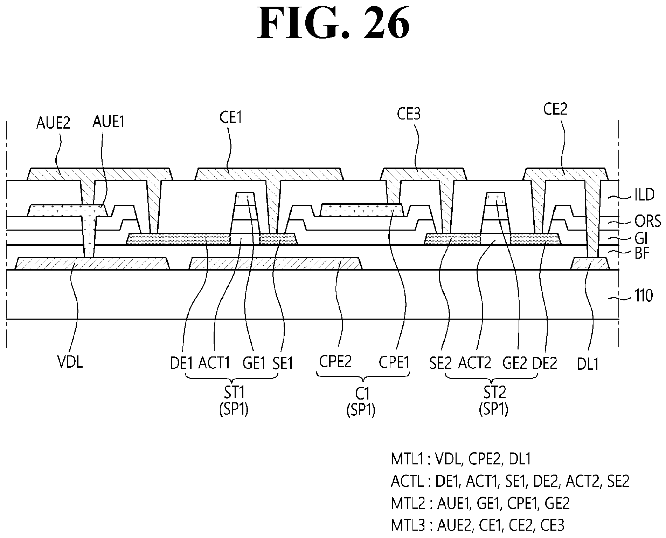

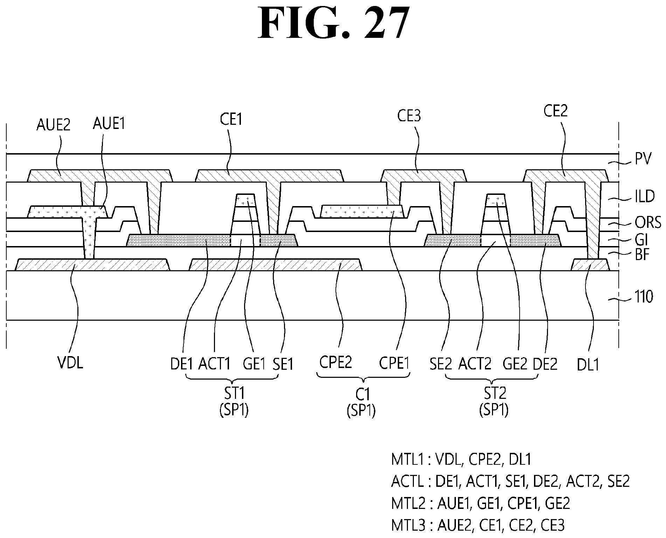

FIG. 17 is a flowchart for illustrating a method of fabricating a display device according to an embodiment of the disclosure. FIGS. 18 to 27 are schematic cross-sectional views showing processing steps of a method of fabricating a display device according to an embodiment.

Referring to FIGS. 17 to 27, a method S1 of fabricating a display device according to an embodiment may include: forming an active layer on a substrate (step S110); forming a gate insulating film on the active layer (step S120); forming an oxygen-providing film on the gate insulating film (step S130); and forming a metal layer on the oxygen-providing film (step S140).

Firstly, as shown in FIGS. 18 to 20, step S110 of forming the active layer on the substrate may include patterning a first metal layer MTL1 on a first substrate 110, covering a buffer film BF on the first metal layer MLT1, and forming an active layer ACTL on the buffer film BF.

The first metal layer MTL1 may be formed on the first substrate 110 via a photolithography process. The first metal layer MTL1 may be made up of a single layer or multiple layers of at least one of molybdenum (Mo), aluminium (Al), chromium (Cr), gold (Au), titanium (Ti), nickel (Ni), neodymium (Nd) and copper (Cu) or an alloy thereof.

The buffer film BF may be made up of multiple layers in which one or more inorganic layers of a silicon nitride layer, a silicon oxynitride layer, a silicon oxide layer, a titanium oxide layer and an aluminium oxide layer are alternately stacked on one another.

The active layer ACTL may be formed on the buffer film BF via a photolithography process. The active layer ACTL may be formed of at least one of ITGZO (InSnGaZnO)-based, ITGO (InSnGaO)-based, and IGO (InGaO)-based oxide semiconductor materials.

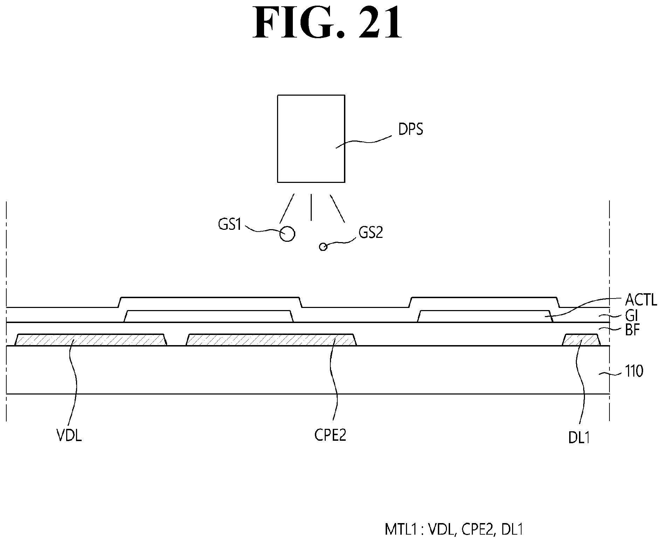

Secondly, in step S120 of forming the gate insulating film on the active layer, as shown in FIG. 21, the gate insulating film GI may be formed on the active layer ACTL. The gate insulating film GI may be formed via a chemical vapor deposition process such as chemical vapor deposition (CVD) and plasma enhanced chemical vapor deposition (PECVD). The gate insulating film GI may include at least one of silicon oxide (SiOₓ), silicon nitride (SiNₓ), and silicon oxynitride (SiOₓN_{y}).

To form the gate insulating film GI via a chemical vapor deposition process, a deposition process may be performed by a deposition apparatus DPS using a first gas GS1 and a second gas GS2 as reactive gases. The first gas GS1 may be a silane (SiH₄) gas, and the second gas GS2 may be a nitrous oxide (N₂O) gas.

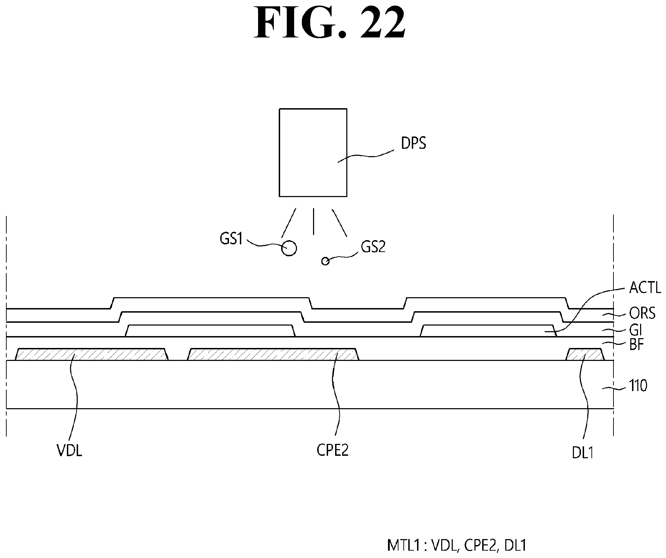

Thirdly, in step S130 of forming the oxygen-providing film on the gate insulating film, as shown in FIG. 22, an oxygen-providing film ORS may be formed on the gate insulating film GI. The oxygen-providing film ORS may be formed via a chemical vapor deposition process such as chemical vapor deposition (CVD) and plasma enhanced chemical vapor deposition (PECVD). The oxygen-providing film ORS may include at least one of silicon oxide (SiOₓ) and silicon oxynitride (SiOₓN_{y}).

To form the oxygen-providing film ORS via a chemical vapor deposition process, a deposition process may be performed by a deposition apparatus DPS using a first gas GS1 and a second gas GS2 as reactive gases. The first gas GS1 may be a silane (SiH₄) gas, and the second gas GS2 may be a nitrous oxide (N₂O) gas.

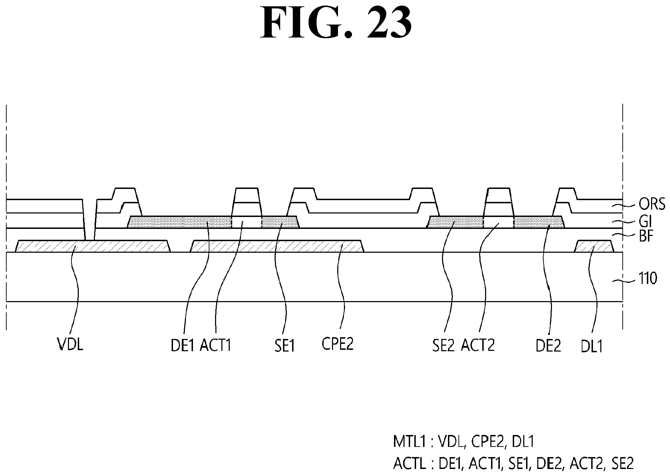

Subsequently, as shown in FIG. 23, a contact hole may be formed by etching at least a part of the gate insulating film GI and the oxygen-providing film ORS. A part of the first metal layer MTL1 and a part of the active layer ACTL may be exposed through the contact hole.

Subsequently, the exposed part of the active layer ACTL may be doped. One side and the opposite side of each of the active areas ACT1 and ACT2 may be doped to form drain electrodes DE1 and DE2 and source electrodes SE1 and SE2, respectively.

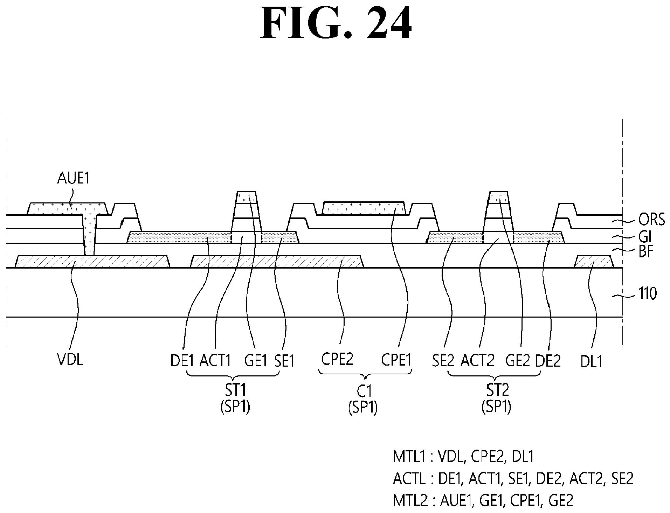

Fourthly, in step S140 of forming the metal layer on the oxygen-providing film, as shown in FIGS. 24 to 27, a second metal layer MTL2 may be patterned on the oxygen-providing film ORS, a second metal layer MTL2 may be covered with an interlayer dielectric film ILD, a third metal layer MTL3 may be patterned on the interlayer insulating film ILD, and a third metal layer MTL3 may be covered with a passivation film PV.

The second metal layer MTL2 may be formed on the first substrate 110 via a photolithography process. The second metal layer MTL2 may be made up of a single layer or multiple layers of at least one of molybdenum (Mo), aluminium (Al), chromium (Cr), gold (Au), titanium (Ti), nickel (Ni), neodymium (Nd) and copper (Cu) or an alloy thereof.

The interlayer dielectric film ILD may be formed of an inorganic layer, for example, a silicon nitride layer, a silicon oxynitride layer, a silicon oxide layer, a titanium oxide layer, and/or an aluminium oxide layer.

The third metal layer MTL3 may be formed on the first substrate 110 via a photolithography process. The third metal layer MTL3 may be made up of a single layer or multiple layers of at least one of molybdenum (Mo), aluminium (Al), chromium (Cr), gold (Au), titanium (Ti), nickel (Ni), neodymium (Nd) and copper (Cu) or an alloy thereof.

The protective film PV may be formed of an inorganic layer, for example, a silicon nitride layer, a silicon oxynitride layer, a silicon oxide layer, a titanium oxide layer, and/or an aluminium oxide layer.

According to the method S1 of fabricating a display device according to an embodiment, a first ratio, which is the ratio of the flow rate of the first gas GS1 to the flow rate of the second gas GS2 in step S130 of forming the oxygen-providing film on the gate insulating film may be smaller than a second ratio, which is the ratio of the flow rate of the first gas GS1 to the flow rate of the second gas GS2 in step S120 of forming the gate insulating film on the active layer. For example, the first ratio may be equal to or less than about 1:55, and the second ratio may be greater than about 1:55. As the first ratio is smaller than the second ratio, the oxygen-providing film ORS having a higher oxygen content than the gate insulating film GI can be formed.

Hereinafter, a method of fabricating a display device according to another embodiment of the disclosure will be described. In the following description, the same or similar elements will be denoted by the same or similar reference numerals, and redundant descriptions will be omitted or briefly described. Descriptions will focus on differences from the above embodiment.

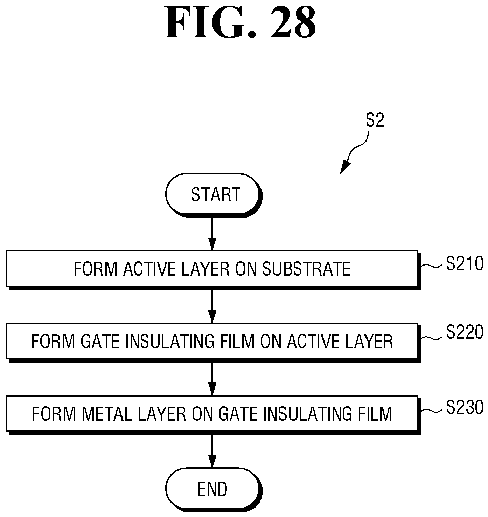

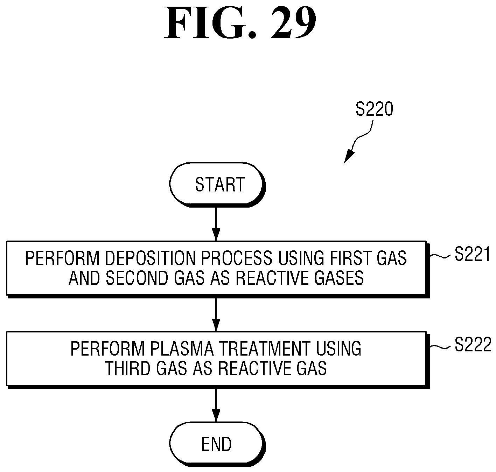

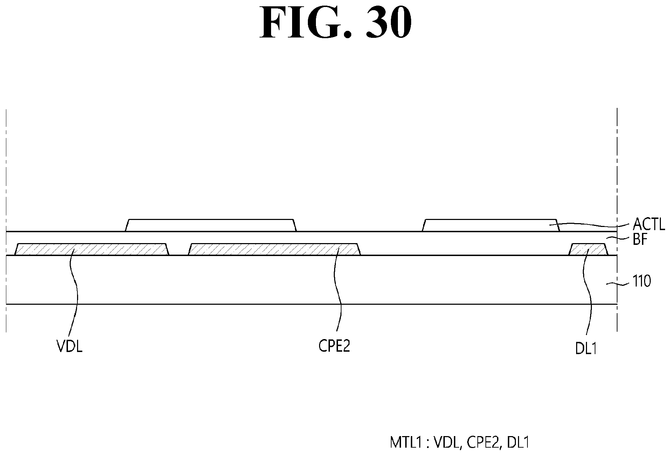

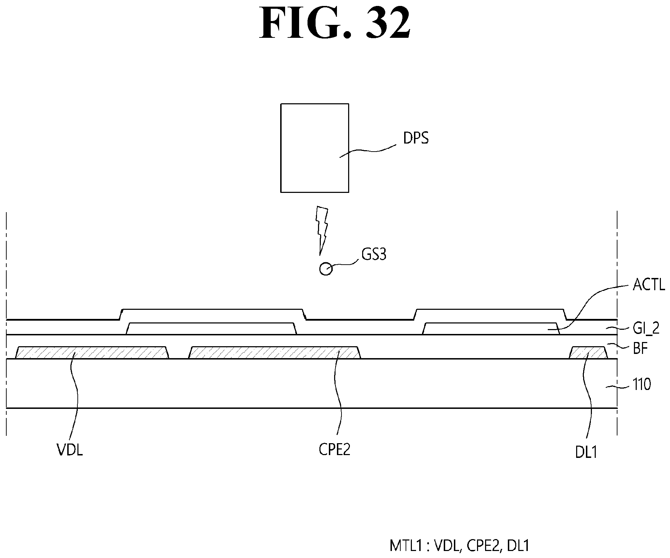

FIG. 28 is a flowchart for illustrating a method of fabricating a display device according to another embodiment of the disclosure. FIG. 29 is a flowchart for illustrating step S220 of FIG. 28. FIGS. 30 to 35 are schematic cross-sectional views showing processing steps of a method of fabricating a display device according to another embodiment of the disclosure.

A method S2 of fabricating a display device according to an embodiment of FIGS. 28 to 35 may be different from the method S1 of fabricating a display device according to an embodiment described above with reference to FIG. 17 and the like at least in that the former may include no oxygen-providing film ORS and performs plasma treatment on a gate insulating film GI.

More specifically, the method S2 of fabricating a display device according to another embodiment may include forming an active layer on a substrate (step S210), forming a gate insulating film on the active layer (step S220), and forming a metal layer on the gate insulating film (step S230).

Firstly, as shown in FIG. 30, step S210 of forming the active layer on the substrate may include patterning a first metal layer MTL1 on a first substrate 110, covering a buffer film BF on the first metal layer MTL1, and forming an active layer ACTL on the buffer film BF.

The method of forming the first metal layer MTL1, the buffer layer BF and the active layer ACTL may be identical to that of the method S 1 of fabricating a display device according to the above-described embodiment; and, therefore, the redundant descriptions will be omitted.

Secondly, step S220 of forming the gate insulating film on the active layer may include a deposition process (step S221) and a plasma treatment process (step S222), as shown in FIG. 29.

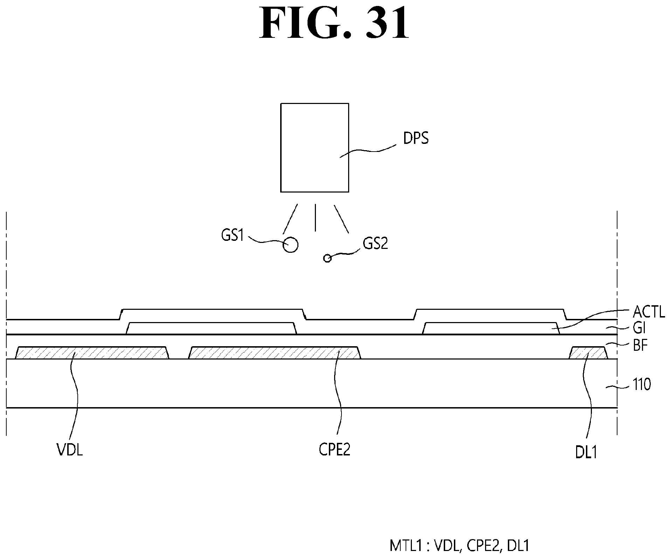

In step S221 of the deposition process, as shown in FIG. 31, a gate insulating film GI may be formed on the active layer ACTL. The gate insulating film GI may be formed via a chemical vapor deposition process such as chemical vapor deposition (CVD) and plasma enhanced chemical vapor deposition (PECVD). The gate insulating film GI may include at least one of silicon oxide (SiOₓ), silicon nitride (SiNₓ), and silicon oxynitride (SiOₓN_{y}).

To form the gate insulating film GI via a chemical vapor deposition process, a deposition process may be performed by a deposition apparatus DPS using a first gas GS1 and a second gas GS2 as reactive gases. The first gas GS 1 may be a silane (SiH₄) gas, and the second gas GS2 may be a nitrous oxide (N₂O) gas.

In step S222 of the plasma treatment process, the deposition apparatus DPS may perform the plasma treatment process using a third gas GS3 as a reactive gas. The third gas GS3 may include at least one of nitrous oxide (N₂O) gas and oxygen (O₂) gas. Such particles of the third gas GS3 ionized by the plasma treatment may penetrate into the gate insulating film GI. As a result, the oxygen content of the gate insulating film GI may increase, and the amount of oxygen releasable from the gate insulating film GI may also increase.

According to the method S2 of fabricating the display device according to an embodiment, instead of disposing the gate insulating film GI having a higher oxygen content directly on the active layer ACTL, ionized oxygen particles may be introduced into the gate insulating film GI having a lower oxygen content, so that the amount of releasable oxygen can be controlled.

In some embodiments, in case that a PECVD process is performed as step S221 of the deposition process, the energy level of the plasma in the PECVD process of step S221 of the deposition process may be greater than the energy level of the plasma in step S222 of the plasma treatment process. The flow rate of the second gas GS2 in step S221 of the deposition process may be smaller than the flow rate of the third gas GS3 in step S222 of the plasma treatment process.

In the method S2 of fabricating a display device according to an embodiment, by lowering the plasma energy and increasing the flow rate of the reactive gas containing oxygen in step S222 of the plasma treatment process than in step S221 of the deposition process, oxygen particles may be additionally added to the gate insulating film GI having a lower oxygen content.

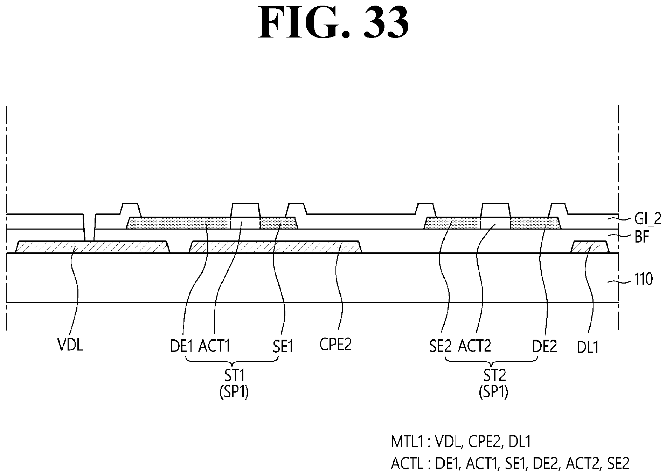

Subsequently, as shown in FIG. 33, a contact hole may be formed by etching at least a part of the gate insulating film GI_2 and the oxygen-providing film ORS. A part of the first metal layer MTL1 and a part of the active layer ACTL may be exposed through the contact hole.

Subsequently, the exposed part of the active layer ACTL may be doped. One side and the opposite side of each of the active areas ACT1 and ACT2 may be doped to form drain electrodes DE1 and DE2 and source electrodes SE1 and SE2, respectively.

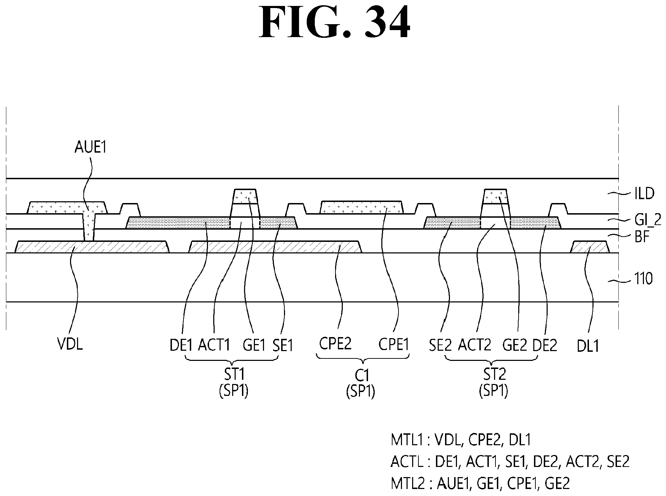

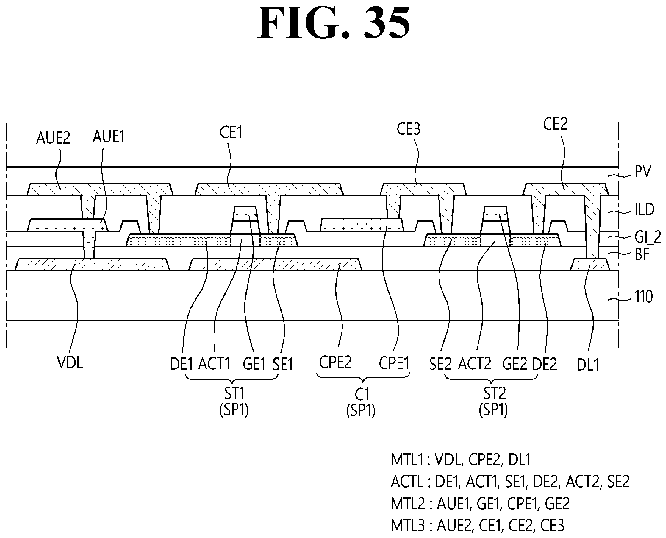

Thirdly, as shown in FIGS. 34 and 35, step S230 of forming the metal layer on the gate insulating film may include patterning a second metal layer MTL2 on the gate insulating film GI_2, covering the second metal layer MTL2 with an interlayer dielectric film ILD, patterning a third metal layer MTL3 on the interlayer dielectric film ILD, and covering the third metal layer MTL3 with a passivation layer PV.

The method of forming the second metal layer MTL2, the interlayer dielectric film ILD, the third metal layer MTL3 and the passivation layer PV may be identical to that of the method S1 of fabricating a display device according to the above-described embodiment; and, therefore, the redundant descriptions will be omitted.

In concluding the detailed description, those skilled in the art will appreciate that many variations and modifications can be made to the embodiments without substantially departing from the principles of the disclosure. Therefore, the disclosed embodiments are used in a generic and descriptive sense only and not for purposes of limitation.

The present invention may be defined by reference to the following clauses:
Clause 1. A display device, comprising:
   a circuit layer disposed on a substrate and comprising a first transistor; and
   a light-emitting element disposed on the circuit layer and electrically connected to the first transistor, wherein
   the first transistor comprises:
      a first active area;
      a first drain electrode disposed on a side of the first active area;
      a first source electrode disposed on another side of the first active area;
      a gate insulating film disposed on the first active area;
      an oxygen-providing film disposed on the gate insulating film; and a first gate electrode disposed on the oxygen-providing film, and
   the oxygen-providing film has a higher oxygen ratio than the gate insulating film.
Clause 2. The display device of clause 1, wherein the oxygen-providing film overlaps the first active area in the first transistor.
Clause 3. The display device of clause 1 or clause 2, wherein the first active area is disposed under the oxygen-providing film.
Clause 4. The display device of any one of clauses 1 to 3, wherein
   the oxygen-providing film directly contacts the gate insulating film, and
   the gate insulating film directly contacts the first active area.
Clause 5. The display device of any one of clauses 1 to 4, wherein
   the oxygen-providing film is spaced apart from the first active area, and
   the gate insulating film is disposed between the oxygen-providing film and the first active area.
Clause 6. The display device of any one of clauses 1 to 5, wherein an amount of oxygen released from the oxygen-providing film is greater than an amount of oxygen released from the gate insulating film.
Clause 7. The display device of clause 6, wherein the amount of oxygen released from the oxygen-providing film is about three times or more the amount of oxygen released from the gate insulating film.
Clause 8. The display device of any one of clauses 1 to 7, wherein a total amount of oxygen released from the oxygen-providing film under conditions of a rising-temperature velocity of about 60°C/min and a temperature range of about 50°C to about 1,200°C using a thermal desorption spectroscopy (TDS) is equal to or greater than about 2.5×10¹⁴ molecules/cm².
Clause 9. The display device of any one of clauses 1 to 8, wherein
   the gate insulating film and the oxygen-providing film comprise silicon oxide (SiOₓ), an O/Si ratio of the gate insulating film is less than about 1.83, and
   an O/Si ratio of the oxygen-providing film is equal to or greater than about 1.83.
Clause 10. The display device of any one of clauses 1 to 9, wherein a thickness of the oxygen-providing film is in a range of from about two to about five times a thickness of the gate insulating film.
Clause 11. The display device of any one of clauses 1 to 10, wherein a thickness of the oxygen-providing film is in a range of from about 20 nm to about 50 nm.
Clause 12. The display device of any one of clauses 1 to 11, wherein
   the oxygen-providing film comprises depressions and elevations on an upper surface, and
   a maximum height difference between the depressions and elevations is less than about 2 nm.
Clause 13. The display device of any one of clauses 1 to 12, wherein the first active area comprises at least one of an ITGZO-based semiconductor, an ITGO-based semiconductor, and an IGO-based oxide semiconductor.
Clause 14. The display device of any one of clauses 1 to 13, wherein
   the circuit layer further comprises a second transistor and a third transistor,
   the second transistor comprises:
      a second active area;
      a second drain electrode disposed on one side of the second active area;
      a second source electrode disposed on another side of the second active area;
      the gate insulating film disposed on the second active area; and
      a second gate electrode disposed on the gate insulating film,
   the third transistor comprises:
      a third active area;
      a third drain electrode disposed on one side of the third active area;
      a third source electrode disposed on another side of the third active area;
      a gate insulating film disposed on the third active area; and a third gate electrode disposed on the gate insulating film, and
   at least one of the second transistor and the third transistor does not comprise the oxygen-providing film disposed on the gate insulating film.
Clause 15. The display device of clause 14, wherein
   one of the first transistor, the second transistor and the third transistor is a driving transistor for driving the light-emitting element, and
   the other two of the first transistor, the second transistor and the third transistor are switching transistors for controlling electric current flowing through the driving transistor and the light-emitting element.
Clause 16. A method of fabricating a display device, the method comprising:
   forming an active layer on a substrate;
   forming a gate insulating film on the active layer;
   forming an oxygen-providing film on the gate insulating film; and
   forming a metal layer on the oxygen-providing film, wherein
   the forming of the gate insulating film comprises performing a deposition process using a first gas and a second gas as reactive gases,
   the forming of the oxygen-providing film comprises performing a deposition process using the first gas and the second gas as reactive gases,
   the first gas is silane (SiH₄) gas,
   the second gas is nitrous oxide (N₂O) gas, and
   a ratio of a flow rate of the first gas to a flow rate of the second gas in the forming of the oxygen-providing film is smaller than a ratio of a flow rate of the first gas to a flow rate of the second gas in the forming of the gate insulating film.
Clause 17. The method of clause 16, wherein the ratio of the flow rate of the first gas to the flow rate of the second gas is less than or equal to about 1:55 in the forming of the oxygen-providing film.
Clause 18. The method of clause 16 or clause 17, wherein
   the gate insulating film and the oxygen-providing film comprise silicon oxide (SiOₓ), an O/Si ratio of the gate insulating film is less than about 1.83, and
   an O/Si ratio of the oxygen-providing film is equal to or greater than about 1.83.
Clause 19. A method of fabricating a display device, the method comprising:
   forming an active layer on a substrate;
   forming a gate insulating film on the active layer; and
   forming a metal layer on an oxygen-providing film, wherein
   the forming of the gate insulating film comprises:
      performing a deposition process using a first gas and a second gas as reactive gases; and
      performing a plasma treatment process using a third gas as a reactive gas, the first gas is silane (SiH₄) gas,
   the second gas is nitrous oxide (N₂O) gas, and
   the third gas comprises at least one of nitrous oxide (N₂O) gas and oxygen (O₂) gas.
Clause 20. The method of clause 19, wherein
   the performing of the deposition process is performed using a PECVD process,
   an energy level of a plasma in the PECVD process of the deposition process is greater than an energy level of a plasma in the plasma treatment process, and
   a flow rate of the second gas in the deposition process is smaller than a flow rate of the third gas in the plasma treatment process.

## Claims

1. A display device, comprising:
a circuit layer disposed on a substrate and comprising a first transistor; and
a light-emitting element disposed on the circuit layer and electrically connected to the first transistor, wherein
the first transistor comprises:
a first active area;
a first drain electrode disposed on a side of the first active area;
a first source electrode disposed on another side of the first active area;
a gate insulating film disposed on the first active area;
an oxygen-providing film disposed on the gate insulating film; and
a first gate electrode disposed on the oxygen-providing film, and
the oxygen-providing film has a higher oxygen ratio than the gate insulating film.

2. The display device of claim 1, wherein the oxygen-providing film overlaps the first active area in the first transistor.

3. The display device of claim 1 or claim 2, wherein the first active area is disposed under the oxygen-providing film.

4. The display device of any one of claims 1 to 3, wherein
the oxygen-providing film directly contacts the gate insulating film, and/or
the gate insulating film directly contacts the first active area.

5. The display device of any one of claims 1 to 4, wherein
the oxygen-providing film is spaced apart from the first active area, and
the gate insulating film is disposed between the oxygen-providing film and the first active area.

6. The display device of any one of claims 1 to 5, wherein an amount of oxygen releasable from the oxygen-providing film is greater than an amount of oxygen releasable from the gate insulating film;
optionally wherein the amount of oxygen releasable from the oxygen-providing film is about three times or more the amount of oxygen releasable from the gate insulating film.

7. The display device of any one of claims 1 to 6, wherein a total amount of oxygen releasable from the oxygen-providing film under conditions of a rising-temperature velocity of about 60°C/min and a temperature range of about 50°C to about 1,200°C using a thermal desorption spectroscopy (TDS) is equal to or greater than about 2.5×10¹⁴ molecules/cm².

8. The display device of any one of claims 1 to 7, wherein
the gate insulating film and the oxygen-providing film comprise silicon oxide (SiOₓ), an O/Si ratio of the gate insulating film is less than about 1.83, and
an O/Si ratio of the oxygen-providing film is equal to or greater than about 1.83.

9. The display device of any one of claims 1 to 8, wherein a thickness of the oxygen-providing film is in a range of from about two to about five times a thickness of the gate insulating film; and/or
wherein a thickness of the oxygen-providing film is in a range of from about 20 nm to about 50 nm.

10. The display device of any one of claims 1 to 9, wherein
the oxygen-providing film comprises depressions and elevations on an upper surface, and
a maximum height difference between the depressions and elevations is less than about 2 nm; and/or
wherein the first active area comprises at least one of an ITGZO-based semiconductor, an ITGO-based semiconductor, and an IGO-based oxide semiconductor.

11. The display device of any one of claims 1 to 10, wherein
the circuit layer further comprises a second transistor and a third transistor,
the second transistor comprises:
a second active area;
a second drain electrode disposed on one side of the second active area;
a second source electrode disposed on another side of the second active area;
the gate insulating film disposed on the second active area; and
a second gate electrode disposed on the gate insulating film,
the third transistor comprises:
a third active area;
a third drain electrode disposed on one side of the third active area;
a third source electrode disposed on another side of the third active area;
a gate insulating film disposed on the third active area; and
a third gate electrode disposed on the gate insulating film, and
at least one of the second transistor and the third transistor does not comprise the oxygen-providing film disposed on the gate insulating film;
optionally wherein
one of the first transistor, the second transistor and the third transistor is a driving transistor for driving the light-emitting element, and
the other two of the first transistor, the second transistor and the third transistor are switching transistors for controlling electric current flowing through the driving transistor and the light-emitting element.

12. A method of fabricating a display device, the method comprising:
forming an active layer on a substrate;
forming a gate insulating film on the active layer;
forming an oxygen-providing film on the gate insulating film; and
forming a metal layer on the oxygen-providing film, wherein
the forming of the gate insulating film comprises performing a deposition process using a first gas and a second gas as reactive gases,
the forming of the oxygen-providing film comprises performing a deposition process using the first gas and the second gas as reactive gases,
the first gas is silane (SiH₄) gas,
the second gas is nitrous oxide (N₂O) gas, and
a ratio of a flow rate of the first gas to a flow rate of the second gas in the forming of the oxygen-providing film is smaller than a ratio of a flow rate of the first gas to a flow rate of the second gas in the forming of the gate insulating film.

13. The method of claim 12, wherein the ratio of the flow rate of the first gas to the flow rate of the second gas is less than or equal to about 1:55 in the forming of the oxygen-providing film; and/or
wherein
the gate insulating film and the oxygen-providing film comprise silicon oxide (SiOₓ), an O/Si ratio of the gate insulating film is less than about 1.83, and
an O/Si ratio of the oxygen-providing film is equal to or greater than about 1.83.

14. A method of fabricating a display device, the method comprising:
forming an active layer on a substrate;
forming a gate insulating film on the active layer; and
forming a metal layer on the gate insulating film, wherein
the forming of the gate insulating film comprises:
performing a deposition process using a first gas and a second gas as reactive gases; and
performing a plasma treatment process using a third gas as a reactive gas, the first gas is silane (SiH₄) gas,
the second gas is nitrous oxide (N₂O) gas, and
the third gas comprises at least one of nitrous oxide (N₂O) gas and oxygen (O₂) gas.

15. The method of claim 14, wherein
the performing of the deposition process is performed using a PECVD process,
an energy level of a plasma in the PECVD process of the deposition process is greater than an energy level of a plasma in the plasma treatment process, and
a flow rate of the second gas in the deposition process is smaller than a flow rate of the third gas in the plasma treatment process.
